(19) Europäisches Patentamt / European Patent Office / Office européen des brevets

(11) **EP 2 557 147 B1**

(12) **EUROPEAN PATENT SPECIFICATION**

(45) Date of publication and mention
of the grant of the patent:
**01.04.2015 Bulletin 2015/14**

(21) Application number: **11176892.5**

(22) Date of filing: **09.08.2011**

(51) Int Cl.:
*C11D 11/00* (2006.01)      *H01L 31/18* (2006.01)
*C11D 3/00* (2006.01)      *C11D 7/06* (2006.01)
*C11D 7/26* (2006.01)      *C11D 7/32* (2006.01)
*C11D 7/34* (2006.01)      *C11D 7/36* (2006.01)
*H01L 21/02* (2006.01)

(54) **Aqueous alkaline compositions and method for treating the surface of silicon substrates**

Wässrige basische Lösung und Verfahren zur Behandlung der Oberfläche von Siliziumsubstraten

Compositions aqueuses alcalines et procédé de traitement de la surface de substrats de silicium

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**13.02.2013 Bulletin 2013/07**

(73) Proprietor: **BASF SE
67056 Ludwigshafen (DE)**

(72) Inventors:
• **Ferstl, Berthold
64625 Bensheim (DE)**
• **Berthold, Ferstl
64625 Bensheim (DE)**

(56) References cited:
EP-A1- 1 736 534      EP-A1- 1 808 480
EP-A1- 2 281 867      EP-A2- 1 564 595
EP-A2- 1 914 296

**Description**

**Field of the Invention**

The present invention is directed to a novel aqueous alkaline composition useful for treating the surface of silicon substrates.

Moreover, the present invention is directed to a novel method for treating the surface of silicon substrates making use of the novel aqueous alkaline composition.

Additionally, the present invention is directed to a novel method for manufacturing devices generating electricity upon the exposure to electromagnetic radiation making use of the novel aqueous alkaline composition and the novel method for treating the surface of silicon substrates.

**Background of the Invention**

In the industrial production of solar cells, monocrystalline or polycrystalline silicon wafers are cut from massive ingots mainly by sawing. This creates a rough surface having a mean surface roughness of about 20 to 30 $\mu$m, customarily referred to in the the art as saw damage. This saw damage is usually caused by metal attrition of the sawing wire and residual abrasives. It is therefore necessary to carry out a so-called saw damage etch to remove the surface roughness and to texturize the silicon wafer surface. This way, a certain roughness is created at the surface which roughness enables the multiple reflection of light incident on the surface, thereby leading to greater absorption of the light inside the silicon wafer, i.e., to an increased light-confining effect.

Following the texturization, short treatments of the textured wafers with either water or alkaline or acidic solutions can be carried out. Alternatively or additionally, a conventional finishing by a short treatment with a hydrogen fluoride containing solution can be carried out. The hydrogen fluoride removes the natural oxide layer at the surface of the silicon wafers accompanied by the formation of silicium-fluorine bonds. This way, an activated hydrophobic silicon surface is created.

The silicon tetrafluoride which is generated as an intermediary by the hydrofluoric acid treatment can react with water to produce colloidal silicon dioxide particles which tend to adhere to the activated silicon surface and may form spots or stains called "haze". Additionally, due to the surface tension of the water, the hydrophobicity of the surface leads to the formation of water droplets during the rinsing step. The colloidal particles however tend to concentrate on the vapor-liquid boundaries of the droplets. During the drying step the droplets can roll along the silicon wafer surface such that the colloidal particles contained in the droplets adhere to and re-contaminate the silicon wafer surface.

Moreover, the hydrophobic silicon wafer surface can hardly be wetted by highly polar spray-on emitter sources, in particular highly polar spray-on phosphorus emitter sources such as aqueous or alcoholic phosphoric acid. Therefore, the silicon wafer surfaces have to be rendered hydrophilic before they can be contacted with the spray-on emitter source.

Many aqueous alkaline etching and cleaning compositions for the treatment of the surface of silicon wafers have been proposed in the prior art.

EP 1 808:480 A1 (AIR PROD & CHEM [US]) 18 July 2007 (2007-07-18), EP 2 281 867 A1 (AIR PROD& CHEM [US]) 9 February 2011 (2011-02-09), and EP 1 914 296 A2 (AIR PROD & CHEM [US]) 23 April 2008 (2008-04-23), for example, form prior art relevant for the present invention.

The Japanese patent application JP 50-158281 discloses the use of an aqueous solution of tetramethylammonium hydroxide (TMAH) and hydrogen peroxide for the cleaning of semiconductor wafer surfaces.

The American patent US 4,239,661 proposes the use of an aqueous solution containing choline and hydrogen peroxide and additionally containing nonionic surfactants such as aliphatic esters of polyhydric alcohols or polyethyleneoxides, complexing agents such as cyanide or ethylenediaminetetraacetic acid (EDTA), triethanolamine, ethylenediamine or cuproin, for treating and washing of the surface of intermediate semiconductor products, the etching of metal layers and the removal of positive-working photoresists.

The German patent application DE 27 49 636 discloses the use of an aqueous composition containing TMAH, hydrogen peroxide, complexing agents such as ammonium hydroxide or pyrocatechol; which compounds are deemed complexing agents by the reference, fluorinated compounds as surfactants such as hexafluoroisopropanol, and ammonium fluoride, ammonium biphosphate or oxygen, which compounds are deemed inhibitors by the reference.

The Japanese patent application JP 63-048830 discloses the removal of metal impurities from silicon substrate surfaces after a hydrofluoric acid treatment with an aqueous composition containing choline and hydrogen peroxide.

The Japanese patent application JP 63-274149 discloses the degreasing and the removal of inorganic contaminants from semiconductor wafer surfaces with aqueous compositions containing TMAH, hydrogen peroxide and nonionic surfactants.

The American patent US 5,129,955 describes the cleaning and the hydrophilization of silicon wafer surfaces after the hydrofluoric acid treatment with an aqueous solution of choline or TMAH and hydrogen peroxide.

Likewise, the American patent US 5,207,866 discloses the use of such compositions for the anisotropic etching of monocrystalline silicon.

The European patent application EP 0 496 602 A2 describes the removal of metal impurities from silicon wafers surfaces with aqueous compositions containing TMAH, hydrogen peroxide and complexing agents such as phosphonic acids or polyphosphoric acids.

The American patent US 5,705,089 describes the removal of metal impurities from silicon wafers with aqueous compositions containing TMAH, hydrogen peroxide, complexing agents such as polyphosphonic acids, wetting agents such as polyhydric alcohols and anionic, cationic, nonionic and fluorinated surfactants, water-soluble organic additives such as alcohols, glycols, carboxylic acids, hydroxycarboxylic acids, polycarboxylic acids and polyhydric alcohols which may also be oxidized.

The European patent application EP 0 665 582 A2 proposes aqueous compositions containing TMAH, hydrogen peroxide and complexing agents having at least three N-hydroxylaminocarbamoyl groups as surface treating compositions for semiconductors and for the removal of metal ions.

The American patent US 5,466,389 discloses the cleaning of silicon wafers leading to a reduced surface microroughness with aqueous compositions containing TMAH, hydrogen peroxide, nonionic surfactants, complexing agents and buffering components such as inorganic mineral acids and their salts, ammonium salts, weak organic acids and their salts and weak acids and their conjugate bases.

The American patent US 5,498,293 proposes for this purpose aqueous compositions containing TMAH, hydrogen peroxide, amphoteric surfactants such as betaines, sulfobetaines, aminocarboxylic acid derivatives, iminodiacids, amine oxides, fluoroalkyl sulfonates or fluorinated alkyl amphoterics, complexing agents, and a propylene glycol ether solvent.

The American patent US 6,465,403 B1 discloses alkaline cleaning and stripping compositions containing TMAH, hydrogen peroxide, quaternary ammonium silicates, complexing agents, water-soluble organic solvents, and amphoteric, nonionic, anionic or cationic surfactants.

The American patent US 6,585,825 B1 discloses similar compositions additionally containing bath stabilizing agents such as weakly acidic or basic compounds, e.g., salicylic acid.

The American patent US 6,417,147 describes cleaning compositions for removing contamination from the surface of semiconductor wafers, the compositions containing TMAH, hydrogen peroxide, fluorine containing anionic surfactants such as fluorinated alkenyl sulfonic acids having at least 6 carbon atoms to the molecule, alkanolamines, and nonionic surfactants.

The international patent application WO 02/33033 A1 discloses cleaning compositions for semiconductor wafers having metal lines and vias, the said compositions containing TMAH, hydrogen peroxide, a bath stabilizing agent such as salicylic acid, water-soluble silicates, complexing agents, and organic solvents.

The American patent application US 2006/0154839 A1 discloses the use of aqueous compositions containing TMAH, hydrogen peroxide and phosphite or hypophosphite as stripping and cleaning compositions primarily for ash residue removal.

The American patent application US 2006/0226122 discloses aqueous etching compositions containing TMAH, hydrogen peroxide, and aromatic sulfonic acids such as benzyl sulfonic acid. The compositions are primarily used for the selective wet etching of metal nitrides.

The American patent application US 2010/0319735 A1 discloses cleaning compositions which are capable of removing both organic soiling and particulate soiling adhered to a substrate for an electronic device. The cleaning compositions contain a water-soluble salt containing a transition metal, a chelating agent and a peroxide. Additionally, the cleaning compositions can contain alkali agents such as ammonia, tetramethylammonium hydroxide and tetraethylammonium hydroxide, anionic surfactants such as linear alkyl benzenesulfonates, alkyl sulfates and alkylether sulfates, and nonionic surfactants such as alkyleneoxide adducts of higher alcohols.

However, the hydrophilizing effect of these prior art etching and cleaning compositions needs considerable improvement in order to be able to meet the increasingly stricter demands of the modern processes for manufacturing highly efficient solar cells.

In particular, the unsatisfactory hydrophilicity of the surfaces of the silicon substrates, especially, of the surface of silicon wafer surfaces, makes it difficult to evenly distribute highly polar spray-on emitter sources, in particular highly polar spray-on phosphorus emitter sources, which, in turn, leads to an unsatisfactory phosphorus doping and, consequently, to solar cells having an unacceptably low efficiency.

After the removal of the etching and cleaning compositions, the emitter sources, in particular the phosphorus emitter sources, can be applied single-sided or double-sided onto the silicon wafer surfaces in the next process step. The applied emitter sources are heated, for example, in an infrared-heated belt furnace so that the emitter diffuses into the silicon substrate.

In this process step, a layer or zone of silicate glass SG, in particular phosphorus silicate glass (PSG), and a second zone the so-called dead layer, which consists of non-electrically active emitters, in particular phosphorus, are formed on top of the surface of the silicon wafers.

However, whereas the SG layer, in particular the PSG layer, can be substantially removed by a hydrofluoric acid treatment in the next process step, this is not the case with the dead layer. The dead layer however impairs the electrical characteristics of the solar cells and particularly decreases the short-circuit current and thereby the efficiency.

In the art, gaseous emitter sources such as boron halides or $POCl_3$ can also be used for the generation of emitters in the silicon substrate. In this case, no hydrophilizing step is required after the texturization of the silicon substrate. However, the problems associated with the dead layer remaining after the SG layer removal still need to be remedied.

Moreover, the emitter layer which is present on both sides and/or on the edges of the silicon substrate after the emitter doping must be isolated to prevent short-circuiting the solar cell. Edge isolation can be accomplished by laser edge isolation techniques after the metallization step or by wet chemical etching.

The wet chemical edge isolation is accomplished by immersing the rear side and the edges of the silicon substrate in a hydrogen fluoride containing composition. Due to surface tension effects between the substrate and the hydrogen fluoride containing composition, the emitter layer on the front side is not exposed to the etching. However, residues of porous silicon can remain which must be removed before the further processing of the silicon substrate.

Therefore, in modern process sequences for manufacturing devices generating electricity upon exposure to electromagnetic radiation, additional wet cleaning and surface modification steps followed by rinsing and drying are carried out after the SG in particular PSG removal step and/or the wet edge isolation step and before an antireflection coating like a silicon nitride ($SiN_x$:H) is applied, for example, by physically enhanced chemical vapor deposition (PECVD). By way of such an additional wet cleaning and surface modification step the debris which is left over from the SG removal step and/or the wet edge isolation step and/or has re-contaminated the silicon wafer surface as well as the dead layer and/or porous silicon residues are removed and the surface is modified by etching and oxidation.

It would be highly desirable, both in economic and technical terms, if the etching and cleaning compositions used in the hydrophilizing step could also be used for the additional wet cleaning and surface modification steps. The prior art etching and cleaning fifth compositions may be suitable for both purposes to a certain extent. However, further improvements are needed in order to meet the ever-increasing technical and economical demands of the solar cell manufacturers.

Moreover, the prior art etching and cleaning compositions show a decrease of their pH during their bath lifetime, i.e. the time period the baths are used for etching and cleaning silicon wafers in the production of solar cells. The decrease can be fast, as for example, two pH units during 250 to 300 hours bath lifetime. Consequently, the etching and cleaning cannot be carried out under stable conditions. Therefore, in order to carry out the process under stable conditions, the pH has to be carefully controlled and adjusted during the bath lifetime and/or the baths have to be renewed more often. Both is economically and technically highly disadvantageous.

## Objects of the Invention

It is the object of the present invention to provide a novel aqueous alkaline composition which is particularly well-suited for treating, in particular etching and cleaning, the surface of silicon substrates, in particular silicon wafers, and does not exhibit the disadvantages of the prior art aqueous alkaline compositions.

Additionally, the novel aqueous alkaline composition should have a particularly high cleaning efficiency so that the formation of haze and the re-contamination of the surface of the silicon substrates are avoided.

Moreover, the novel aqueous alkaline composition should have a particularly strong hydrophilizing effect so that the resulting hydrophilic surface can be exceptionally well wetted with highly polar spray-on emitter sources, in particular highly polar spray-on phosphorus emitter sources such as aqueous or alcoholic phosphoric acid, so that the emitter formation can be controlled precisely.

Additionally, the novel aqueous alkaline composition should also be particularly well-suited as a wet cleaning and modification composition in the additional wet cleaning and modification step carried out after the SG removal step, in particular the PSG removal step. In particular, in the additional wet cleaning and surface modification step, the novel alkaline composition should be capable of substantially completely removing not only the debris which is left over from the SG removal step and/or has re-contaminated the surface of the silicon substrates, but also the dead layer. It should also be capable of modifying the surface by etching and oxidation. In this way the open circuit current and thus the efficiency of the photovoltaic or solar cells should be significantly improved.

Furthermore, the novel aqueous alkaline composition should also be particularly well-suited for removing residues of porous silica remaining after a wet edge isolation step.

Last but not least, the novel aqueous alkaline composition should show a stable pH or only a slight decrease or increase of its pH during their bath lifetime , i.e. the time period the baths are used for etching and cleaning silicon wafers in the production of solar cells.

It is another object of the present invention to provide a novel method for treating the surface of silicon substrates, in particular the surface of silicon wafers, which method does not exhibit the disadvantages of the prior art.

Additionally, the novel method for treating the surface of silicon substrates should have a particularly high cleaning efficiency so that the formation of haze and the re-contamination of the surface of the silicon substrates is avoided.

Moreover, the novel method for treating the surface of silicon substrates should have a particularly strong hydrophilizing effect so that the resulting hydrophilic surface can be exceptionally well wetted with highly polar spray-on emitter sources such as aqueous or alcoholic phosphoric acid so that the doping and the formation of the emitters can be controlled precisely.

Additionally, the novel method for treating the surface of silicon substrates should also be particularly well-suited for carrying out the additional wet cleaning and modification step after the SG removal step. In particular, the additional wet cleaning and surface modification step should be capable of substantially completely removing not only the debris which is left over from the SG removal step and/or has re-contaminated the silicon wafer surface, but also the dead layer. It should also be capable of modifying the surface by etching and oxidation. In this way the open circuit current and thus the efficiency of the photovoltaic or solar cells should be significantly improved.

Furthermore, the novel method for treating the surface of silicon substrates should also be particularly well-suited for removing residues of porous silica remaining after the wet edge isolation step.

Last but not least, the novel method for treating the surface of silicon substrates should be carried out under stable pH conditions during the time period the novel method is carried out. This means that the pH does not change or only slightly increases or decreases during this time period.

It is still another object of the invention to provide novel methods for manufacturing devices generating electricity upon exposure to electromagnetic radiation, in particular photovoltaic cells or solar cells, especially selective emitter solar cells, Passivated Emitter and Rear Cells (PERC), Metal Wrap Through (MWT) solar cells and Emitter Wrap Through (EWT) solar cells, or variations thereof which devices generate electricity upon the exposure to electromagnetic radiation with increased efficiencies and which methods should no longer exhibit the disadvantages of the prior art.

Summary of the Invention

Accordingly, the novel aqueous alkaline composition has been found, the said composition comprising:

(A) at least one quaternary ammonium hydroxide;

(B) at least one component selected from the group consisting of

(b1) water-soluble sulfonic acids and their water-soluble salts of the general formula I:

$$(R^1\text{-}Sp_3^-)_n X^{n+} \qquad (I),$$

(b2) water-soluble phosphonic acids and their water-soluble salts of the general formula II:

$$R\text{-}PO_3^{2-} (X^{n+})_{3-n} \qquad (II),$$

(b3) water-soluble sulfuric acid esters and their water-soluble salts of the general formula III:

$$(RO\text{-}SO_3^-)_n X^{n+} \qquad (III),$$

(b4) water-soluble phosphoric acid esters and their water-soluble salts of the general formula (IV):

$$RO\text{-}PO_3^{2-} (X^{n+})_{3-n} \qquad (IV),$$

and
(b5) water-soluble phosphoric acid esters and their water-soluble salts of the general formula (V):

$$[(RO)_2PO_2^-]_n X^{n+} \qquad (V);$$

wherein the index n = 1 or 2; the variable X is selected from the group consisting of hydrogen, ammonium, alkaline metal and alkaline-earth metal; the variable $R^1$ is selected from the group consisting of aliphatic moieties having 2 to 5 carbon atoms and at least one olefinically unsaturated double bond, and cycloaliphatic moieties having 4 to 6 carbon atoms and at least one olefinically unsaturated double bond; and the variable R is selected from the group consisting of aliphatic moieties having 2 to 5 carbon atoms and at least one olefinically unsaturated double bond, cycloaliphatic moieties having 4 to 6 carbon atoms and at least one olefinically unsaturated double bond, and alkylaryl moieties, wherein the aryl moieties are selected from benzene and naphthalene, the alkyl moieties are selected from methylene, ethane-diyl and propane-diyl and the phosphorus atom in the general formula II is bonded directly and the sulfur atom in the general formula III and the phosphorus atom in the general formulas IV and V are each bonded via an oxygen atom to an aliphatic carbon atom; and

(C) a buffer system wherein at least one component other than water is volatile.

Hereinafter, the novel aqueous alkaline composition is referred to as the "composition of the invention".

Additionally, the novel use of the composition of the invention for the treatment of semiconductor materials has been found, which use is hereinafter referred to as the "use of the invention".

Moreover, a novel method for treating the surface of a silicon substrate has been found, the said method comprising the steps of:

(1) providing an aqueous alkaline composition comprising

(A) at least one quaternary ammonium hydroxide;

(B) at least one component selected from the group consisting of

(b1a) water-soluble sulfonic acids and their water-soluble salts of the general formula I:

$$(R\text{-}SO_3^-)_n X^{n+} \qquad (Ia),$$

(b2) water-soluble phosphonic acids and their water-soluble salts of the general formula II:

$$R\text{-}PO_3^{2-} (X^{n+})_{3-n} \qquad (II),$$

(b3) water-soluble sulfuric acid esters and their water-soluble salts of the general formula III:

$$(RO\text{-}SO_3^-)_n X^{n+} \qquad (III),$$

(b4) water-soluble phosphoric acid esters and their water-soluble salts of the general formula (IV):

$$RO\text{-}PO_3^{2-} (X^{n+})_{3-n} \qquad (IV),$$

and
(b5) water-soluble phosphoric acid esters and their water-soluble salts of the general formula (V):

$$[(RO)_2 PO_2^-]_n X^{n+} \qquad (V);$$

wherein the index n = 1 or 2; the variable X is selected from the group consisting of hydrogen, ammonium, alkaline metal and alkaline-earth metal; and the variable R is selected from the group consisting of aliphatic moieties having 2 to 5 carbon atoms and at least one olefinically unsaturated double bond, cycloaliphatic moieties having 4 to 6 carbon atoms and at least one olefinically unsaturated double bond, and alkylaryl moieties, wherein the aryl moieties are selected from benzene and naphthalene, the alkyl moieties are selected from methylene, ethane-diyl and propane-diyl, and the sulfur atom and the phosphorus atom in the general formulas Ia and II are each bonded directly and the sulfur atom in the general formula III and the phosphorus atom in the general formulas IV and V are each bonded via an oxygen atom to an aliphatic carbon atom; and

(C) a buffer system, wherein at least one component other than water is volatile;

(2) contacting at least one major surface of the silicon substrate at least once with the said aqueous alkaline composition for a time and at a temperature sufficient to obtain a clean hydrophilic surface; and

(3) removing the at least one major surface from the contact with the aqueous alkaline composition.

Hereinafter, the novel method for treating the surface of a silicon substrate is referred to as the "treatment method of the invention".

Moreover, a novel method for manufacturing devices generating electricity upon the exposure to electromagnetic radiation has been found, the said method comprising the steps of

(1.I) texturing at least one major surface of a silicon substrate with an etching composition, thereby generating a hydrophobic surface;

(1.II) hydrophilizing the hydrophobic surface by employing the treatment method of the invention;

(1.III) applying at least one spray-on emitter source onto the hydrophilic surface;

(1.IV) heating the the silicon substrate contacted with the emitter source, thereby forming emitters within the silicon substrate or emitters within the silicon substrate and a silicate glass on top of the surface of the silicon substrate;

(1.V) modifying the upper layer of the silicon substrate containing the emitters or removing the silicate glass from the surface of the silicon substrate and, thereafter, modifying the upper layer of the silicon substrate containing the emitters, thereby obtaining a hydrophobic surface;

(1.VI) hydrophilizing the hydrophobic surface by employing the treatment method of the invention;

(1.VII) depositing an antireflective layer on top of the modified upper layer of the silicon substrate material containing the emitters, thereby obtaining an intermediate; and

(1.VIII) further processing the intermediate to obtain the device;

with the proviso that either the process step (1.II) or the process step (1.VI) is carried out or that both process steps (1.II) and (1.VI) are carried out.

Hereinafter, this novel method for manufacturing devices generating electricity upon the exposure to electromagnetic radiation is referred to as the "first manufacturing method of the invention".

Moreover, a method for manufacturing devices generating electricity upon exposure to electromagnetic radiation has been found, the said method comprising the steps of

(2.I) texturing at least one major surface of a silicon substrate with an etching composition, thereby generating a hydrophobic surface;

(2.II) treating the hydrophobic surface of the silicon substrate in a heated atmosphere containing at least one gaseous emitter source, thereby forming emitters within the silicon substrate or emitters within the silicon substrate and a silicate glass on top of the surface of the silicon substrate;

(2.III) modifying the upper layer of the silicon substrate containing the emitters or removing the silicate glass from the surface of the silicon substrate and, thereafter, modifying the upper layer of the silicon substrate containing the emitters by the treatment method of the invention;

(2.IV) depositing an antireflective layer on top of the modified upper layer of the silicon substrate containing the emitters, thereby obtaining an intermediate; and

(2.V) further processing the intermediate to obtain the device.

Hereinafter, this novel method for manufacturing devices generating electricity upon the exposure to electromagnetic radiation is referred to as the "second manufacturing method of the invention".

## Advantages of the Invention

In view of the prior art discussed above, it was surprising and could not be expected by the skilled artisan that the objects underlying the present invention could be solved by the composition, the use, the treatment method and the first and second manufacturing methods of the invention.

Thus, it was surprising that the composition of the invention no longer exhibited the disadvantages and drawbacks of the prior art aqueous alkaline compositions for treating the surface of silicon substrates, in particular silicon wafers.

It was additionally surprising that the composition of the invention had a particularly high cleaning efficiency so that the formation of haze and the re-contamination of the surfaces of the silicon substrates were avoided.

Moreover, it was surprising that the composition of the invention had a particularly strong hydrophilizing effect so that the resulting hydrophilic surface could be exceptionally well wetted with highly polar spray-on emitter sources such as aqueous or alcoholic phosphoric acid so that the doping and the formation of the emitters could be controlled precisely. Likewise, the surface could be rendered hydrophilic again after the modification of the upper layer of the silicon substrate containing the emitters or after the removal of the silicate glass from the surface of the silicon substrate and the modification the upper layer of the silicon substrate containing the emitters.

Moreover, the composition of the invention was also particularly well-suited as a wet cleaning and modification composition in the additional wet cleaning and modification step carried out after the SG removal step in a process sequence for manufacturing devices, in particular photovoltaic cells and solar cells, generating electricity upon exposure to electromagnetic radiation. In particular, in the additional wet cleaning and surface modification step, the composition of the invention was capable of substantially completely removing not only the debris which was left over from the SG removal step and/or had re-contaminated the silicon wafer surface, but also the dead layer. It was also capable of modifying the surface by etching and oxidation. In this way the open circuit current and thus the efficiency of the photovoltaic or solar cells were significantly improved.

Furthermore, the composition of the invention was particularly well-suited for removing residues of porous silica remaining after a wet edge isolation step.

Last but not least, the composition of the invention showed a stable pH or only a slight decrease or increase of its pH during the bath lifetime, i.e. the time period the baths containing the composition of the invention are used for etching and cleaning silicon wafers in the production of solar cells. And was also surprising that the pH decrease or increase could be tuned in a wide pH range by varying the pH of the virgin composition of the invention.

It was also surprising that the use and the treatment method of the invention did not exhibit the disadvantages and drawbacks of the prior art methods for treating the surface of silicon substrates, in particular silicon wafers.

Moreover, the treatment method of the invention had a particularly high cleaning efficiency so that the formation of haze and the re-contamination of the surfaces of the silicon substrates were avoided.

Furthermore, the treatment method of the invention had a particularly strong hydrophilizing effect so that the resulting hydrophilic surface could be exceptionally well wetted with highly polar spray-on emitter sources such as aqueous or alcoholic phosphoric acid so that the doping and the formation of the emitters could be controlled precisely. Likewise, the surface could be rendered hydrophilic again after the modification of the upper layer of the silicon substrate containing the emitters or after the removal of the silicate glass from the surface of the silicon substrate and the modification the upper layer of the silicon substrate containing the emitters.

Moreover, the treatment method of the invention was particularly well-suited for carrying out the additional wet cleaning and modification step after the SG removal step. In particular, the additional wet cleaning and surface modification step was capable of substantially completely removing not only the debris which was left over from the SG removal step and/or had re-contaminated the surface of the silicon substrate, but also the dead layer. It was also capable of modifying the surface by etching and oxidation. In this way the open circuit current and thus the efficiency of the photovoltaic or solar cells were significantly improved.

Furthermore, the treatment method of the invention was particularly well-suited for removing residues of porous silica remaining after a wet edge isolation step.

Last but not least, the method of the invention could be carried out under stable pH conditions in the time period during which it was carried out. This means that the pH did not change or increased or decreased only slightly during this time period.

It was furthermore surprising that the first and second manufacturing method of the invention no longer exhibited the disadvantages and drawbacks of the prior art manufacturing methods but yielded devices, in particular photovoltaic cells or solar cells, especially selective emitter solar cells, Passivated Emitter and Rear Cells (PERC), Metal Wrap Through (MWT) solar cells and Emitter Wrap Through (EWT) solar cells, or variations thereof which devices generate electricity upon the exposure to electromagnetic radiation with increased efficiencies and fill factors (FF)

### Detailed Description of the Invention

The present invention is directed to the composition of the invention.

The composition of the invention is particularly useful and suitable for treating the surface of silicon substrates, including silicon oxides, silicon alloy materials, in particular silicon germanium alloy materials.

The silicon substrates can be amorphous, monocrystalline or polycrystalline silicon semiconductor materials.

Most preferably, the silicon substrates are silicon wafers useful for manufacturing devices generating electricity upon the exposure to electromagnetic radiation, in particular photovoltaic or solar cells. Such silicon wafers can have different sizes. Preferably, they are 100 to 210 mm square or pseudosquare. Likewise, the thickness of the wafers can vary. Preferably, the thickness is in the range of 80 to 300 $\mu$m.

As is known in the art, silicon wafers can be produced in accordance with known and customary methods. Thus, silicon wafers can be manufactured by cutting silicon ingots or bricks. The single crystal ingots are e.g. grown with the Czochralski (CZ) method, by slowly pulling a seed shaft out of molten silicon, which is contained in a fusion furnace. Also the edge-defined film-fed growth (EFG) or string-ribbon process can be used. The polycrystalline silicon can be produced by heating silicon pieces in a crucible just above their melting temperature. This lets the silicon pieces grow together forming a massive silicon block also called ingot. This ingot is cut into bricks often using band saws. The bricks are finally cut into wafers with wire saws. However, as explained hereinbefore, a saw damage etch must be carried out after the sawing.

After their separation and cleaning from the cutting slurry, the silicon wafers are customarily checked for breakages and other errors, and are sorted into the photovoltaic or solar cell production process.

Customarily, the production process starts with the texturization and the saw damage removal. This is often followed by dipping the silicon wafers into different solutions, including aqueous alkaline and acidic solutions, whereby a hydrophobic wafer surface is obtained.

The composition of the invention is an aqueous composition. This means that the components of the composition hereinafter described are completely dissolved on the molecular level in water, preferably de-ionized water and most preferably ultrapure water.

Preferably, the composition of the invention is applied to the hydrophobic wafer surface.

Preferably, the composition of the invention is a highly diluted aqueous solution of the components hereinafter described. More preferably, it contains, based on the complete weight of the treatment composition, of from 40 to 99.9% by weight, more preferably 45 to 99.8% by weight and most preferably 50 to 99.7% by weight of water.

The composition of the invention is an alkaline or basic composition. Its pH can vary broadly and, therefore, can be easily and precisely adjusted to the particular requirements of the treatment method and the manufacturing method of the invention. Preferably, the pH is from 8 to 13, most preferably 8.5 to 12.

The first essential component of the composition of the invention is at least one, preferably one, quaternary ammonium hydroxide (A).

The quaternary ammonium hydroxides (A) are well-known in the art and described for example in the American patent application US 2006/0226122 A1, page 2, paragraph [0025] to page 3, paragraph [0028], and page 4, paragraph [0037] in detail. Preferably, the quaternary ammonium hydroxides (A) are selected from the group consisting of tetraalkylammonium hydroxides wherein the alkyl groups have 1 to 4 carbon atoms and most preferably 1 to 2 carbon atoms, as for example, tetramethylammonium hydroxide (TMAH) or tetraethylammonium hydroxide (TEAH).

The concentration of the quaternary ammonium hydroxide (A) can also vary broadly and, therefore, can be easily and precisely adjusted to the particular requirements of the treatment method and the manufacturing methods of the invention. Preferably, the concentration is in the range of from 0.01 to 6% by weight, more preferably 0.02 to 5.5% by weight and most preferably 0.03 to 5% by weight, the weight percentages is being based on the complete weight of the composition of the invention.

The second essential component of the composition of the invention is at least one, preferably one, component (B) selected from the group consisting of

(b1) water-soluble sulfonic acids and their water-soluble salts of the general formula I:

$$(R^1\text{-}SO_3^-)_n X^{n+} \qquad (I),$$

(b2) water-soluble phosphonic acids and their water-soluble salts of the general formula II:

$$R\text{-}PO_3^{2-} (X^{n+})_{3-n} \qquad (II),$$

(b3) water-soluble sulfuric acid esters and their water-soluble salts of the general formula III:

$$(RO\text{-}SO_3^-)n X^{n+} \qquad (III),$$

(b4) water-soluble phosphoric acid esters and their water-soluble salts of the general formula (IV):

$$RO\text{-}PO_3^{2-} (X^{n+})_{3-n} \qquad (IV),$$

and

(b5) water-soluble phosphoric acid esters and their water-soluble salts of the general formula (V):

$$[(RO)_2PO_2{}^-]_nX^{n+} \qquad (V);$$

In the context of the present invention, "water-soluble" means that the relevant component (B) is completely dissolved in water on the molecular level.

In the general formulas I and II the index n equals 1 or 2, preferably 1.

The variable X is selected from the group consisting of hydrogen, ammonium, alkali metal and alkaline-earth metal, preferably hydrogen, ammonium and alkali metal, most preferably hydrogen, ammonium and sodium.

The variable $R^1$ of the general formula I is selected from the group consisting of aliphatic moieties having 2 to 5, preferably 2 to 4 and most preferably 2 or 3 carbon atoms and at least one, preferably one olefinically unsaturated double bond, and cycloaliphatic moieties having 4 to 6, preferably 5 or 6 and most preferably 6 carbon atoms and at least one, preferably one, olefinically unsaturated double bond.

The moieties $R^1$ may be substituted with at least one inert, i.e., non-reactive, substituent such as fluorine or chlorine if such a substituent does not impair the solubility of the component (b1) in water. More preferably, the moieties $R^1$ are unsubstituted.

Even more preferably , the moieties $R^1$ are selected from the group consisting of

- vinyl;
- prop-1-en-1-yl, prop-2-en-1-yl (allyl), alpha-methyl-vinyl;
- but-1-en-, but-2-en- and but-1-en-1-yl, 2-methyl-prop-1-en-1-yl, but-2-en-2-yl;
- pent-1-en-1-yl, -2-en-1-yl, -3-en-1-yl and -4-en-1-yl;
- pent-1-en-2-yl, -1-en-2-yl, -3-en-2-yl and -4-en-2-yl;
- pent-1-en-3-yl and -2-en-3-yl;
- 3-methyl-but-1-en-1-yl, -2-en-1-yl and -3-en-1-yl;
- 3-methyl-but-2-en-2-yl and -3-en-2-yl;
- neopent-1-en-1-yl and -2-en-1-yl;
- cyclobut-1-en-1-yl and -2-en-1-yl;
- cyclopent-1-en-1-yl, -2-en-1-yl and -3-en-1-yl; and
- cyclohex-1-en-1-yl, -2-en-1-yl and -3-en-1-yl groups.

Vinyl, prop-1-en-1-yl, prop-2-en-1-yl (allyl) and alpha-methyl-vinyl groups are most preferably used.

Therefore, the components (b1) most preferably used are selected from the group consisting of vinylsulfonic acid, allylsulfonic acid, prop-1-en-1-yl-sulfonic acid, and alpha-methyl-vinyl-sulfonic acid and their sodium and ammonium salts.

The variable R of the general formulas II to V is selected from the group consisting of the aforementioned moieties $R^1$ and alkylaryl moieties. In the Ikylaryl moieties, the aryl moieties are selected from benzene and naphthalene, preferably benzene, and the alkyl moieties are selected from methylene, ethane-diyl and propane-diyl, preferably methylene. the phosphorus atom in the general formula II is bonded directly to an aliphatic carbon atom. The sulfur atom in the general formula III and the phosphorus atom in the general formulas IV and V are each bonded via an oxygen atom to an aliphatic carbon atom.

The aryl moieties may be substituted with at least one inert, i.e., non-reactive, substituent such as fluorine or chlorine if such a substituent does not impair the solubility of the component (b2) in water. More preferably, the aryl moieties are unsubstituted.

Therefore, the components (b2) most preferably used are selected from the group consisting of vinylphosphonic acid, allylphosphonic acid, prop-1-en-1-yl-phosphonic acid, alpha-methyl-vinyl-phosphonic acid and benzylphosphonic and their sodium salts.

The components (b3) most preferably used are selected from the group consisting of monovinyl, monoallyl, monoprop-1-en-1-yl, mono-alpha-methyl-vinyl and monobenzyl sulfuric acid esters and their sodium salts.

The components (b4) most preferably used are selected from the group consisting of monovinyl, monoallyl, monoprop-1-en-1-yl, mono-alpha-methyl-vinyl and monobenzyl phosphoric acid esters and their sodium salts.

The components (b5) most preferably used are selected from the group consisting of divinyl, diallyl, diprop-1-en-1-yl, di-alpha-methyl-vinyl and dibenzyl phosphoric acid esters and their sodium salts. Mixed phosphoric acid esters containing two different residues R can also be used.

The concentration of the component (B) in the composition of the invention can vary broadly and, therefore, can be adjusted easily and precisely to the particular requirements of the relevant treatment method and manufacturing methods of the invention. Preferably, the concentration is in the range of from 0.001 to 5% by weight, more preferably 0.005 to 4.5% by weight and, most preferably, 0.01 to 4% by weight, the weight percentages being based on the complete weight of the composition of the invention.

The third essential component of the composition of the invention is buffer system (C) wherein at least one component other than water is volatile. Preferably, all the components of the buffer system (C) are volatile.

In the context of the present invention, "volatile" means that a volatile component is capable of evaporating completely without leaving a non-volatile residue.

The volatile component can be a volatile acid which is set free from the buffer system (C) upon evaporation. Preferably, the volatile acid is selected from the group consisting of volatile organic and inorganic acids, more preferably, hydrochloric acid, carbonic acid, formic acid and acetic acid and most preferably carbonic acid.

The volatile component can be a volatile base which is set free from the buffer system upon evaporation. Preferably, the volatile base is selected from the group consisting of volatile organic and inorganic bases, more preferably, ammonia, methyl amine, dimethyl amine, trimethyl amine and ethyl amine and most preferably, ammonia.

More preferably, the volatile buffer system (C) is selected from the group consisting of alkali metal carbonates, alkali metal carbonates/ammonia, alkali metal acetates, alkali metal acetates/ammonia, ammonium acetate, ammonium acetate/ammonia, ammonium carbonate and ammonium carbonate/ammonia.

Even more preferably, the buffer system (C) is selected from the group consisting of sodium carbonate, sodium carbonate/ammonia, ammonium carbonate and ammonium carbonate/ammonia.

Most preferably, the buffer system (C) is selected from the group consisting of sodium carbonate/ammonia, ammonium carbonate and ammonium carbonate/ammonia.

The concentration of the buffer system (C) in the composition of the invention can vary broadly and, therefore, can be adjusted easily and precisely to the particular requirements of the relevant treatment method and manufacturing methods off the invention. Preferably, the concentration is in the range of from 0.001 to 10% by weight, more preferably 0.005 to 9% by weight and, most preferably, 0.01 to 8% by weight, the weight percentages being based on the complete weight of the composition of the invention.

In a preferred embodiment, the composition of the invention additionally contains at least one acid (D). Preferably, the acid (D) is volatile so that it is capable of evaporating without the formation of residues at comparatively low temperatures, i.e., temperatures below 200°C.

Particularly preferably, the acid (D) is selected from the group consisting of inorganic mineral acids, most preferably hydrochloric acid and nitric acid, and water-soluble carboxylic acids, most preferably formic acid and acetic acid. Most particularly preferably, a water-soluble carboxylic acid (D) and an inorganic mineral acid (D) are used.

The concentration of the acids (D) in the composition of the invention can vary broadly and, therefore, can be adjusted easily and precisely to the particular requirements of the relevant treatment method and manufacturing method of the invention. Preferably, the concentration of the acid (D) is in the range of from 0.005 to 5% by weight, more preferably 0.01 to 4% by weight and most preferably 0.015 to 3% by weight, the weight percentages being based on the complete weight of the composition of the invention.

In another preferred embodiment, the composition of the invention additionally contains at least one, preferably one, volatile, water-soluble base (E), preferably selected from the group consisting of inorganic and organic bases containing at least one nitrogen atom.

More preferably, the volatile, water-soluble inorganic base (E) containing at least one, preferably one, nitrogen atom is a ammonia or hydroxyl amine, even more preferably ammonia.

Most preferably, the volatile, water-soluble organic base (E) is selected from the group consisting of methyl-, dimethyl-, ethyl-, methylethyl-, diethyl-, 1-propyl- and isopropylamine, 1-aminoethanol, 2-aminoethanol (ethanolamine), diethanolamine and ethylenediamine.

Also the concentration of the volatile, water-soluble base (E) can vary broadly and, therefore, can be adjusted easily and precisely to the particular requirements of the relevant treatment method and manufacturing methods of the invention. Preferably, the concentration is in the range of from 0.05 to 3% by weight, more preferably 0.075 to 2.5% by weight and most preferably 0.1 to 2% by weight, the weight percentages being based on the complete weight of the composition of the invention.

In still another preferred embodiment, the composition of the invention additionally contains at least one, preferably one, oxidizing agent (F) preferably selected from the group consisting of water-soluble organic and inorganic peroxides, more preferably inorganic peroxides, and ozone.

Preferably, the water-soluble organic peroxides (F) are selected from the group consisting of benzoyl peroxide, peracetic acid, urea hydrogen peroxide adduct and di-t-butyl peroxide.

Preferably, the inorganic peroxides (F) are selected from the group consisting of hydrogen peroxide, percarbonates, perborates, monopersulfates, dipersulfates and sodium peroxide.

The concentration of the oxidizing agent (F) in the composition of the invention can vary broadly and, therefore, can be adjusted easily and precisely to the particular requirements of the relevant treatment method and manufacturing methods of the invention. Preferably, the concentration is in the range of from 0.1 to 10 % by weight, more preferably 0.2 to 8% by weight and most preferably 0.3 to 6% by weight, the weight percentages being based on the complete weight of the composition of the invention.

In yet another preferred embodiment, the composition of the invention contains at least one metal chelating agent (G) to increase the capacity of the composition to retain metal ions in solution and to enhance the dissolution of metallic residues on the surface of the silicon wafers. In principle, any customary and known metal chelating agent (G) may be used as long as it does not adversely interfere with the other components of the composition of the invention, e.g., by causing decompositions or unwanted precipitates.

Preferably, the metal chelating agent (G) is selected from the group consisting of carboxylic acids, hydroxycarboxylic acids, amino acids, hydroxyamino acids, phosphonic acids and hydroxyphosphonic acids and their salts, alcohols and phenols containing at least two hydroxyl groups, the said compounds containing or not containing functional groups containing at least one nitrogen atom.

Preferably, the salts of the metal chelating agents (G) are selected from the group consisting of ammonium salts, in particular, ammonium salts, methyl-, dimethyl-, trimethyl-, ethyl-, methylethyl-, diethyl-, methyldiethyl-, triethyl-, 1-propyl- and isopropylammonium salts, and ethanolammonium, diethanolammmonium and ethylenediammonium salts; and alkali metal salts, in particular, sodium and potassium salts.

More preferably, the metal chelating agent (G) is selected from the group consisting of amino acid diacetates and hydroxy amino acid diacetates and their salts, in particular, methylglycine diacetate (MGDA; Trilon™ M; alpha-alanine diacetate), beta-alanine diacetate, glutamic acid diacetate, aspartic acid diacetate, serine diacetates and threonine diacetates and their salts, particularly preferably MGDA and its salts; (ethylenedinitrilo)tetraacetic acid (EDTA), butylenediaminetetraacetic acid, (1,2-cyclohexylenedinitrilo)tetraacetic acid (CyDTA), diethylenetriaminepentaacetic acid, ethylenediaminetetrapropionic acid, (hydroxyethyl)ethylenediaminetriacetic acid (HEDTA), N,N,N',N'-ethylenediaminetetra(methylenephosphonic) acid (EDTMP), triethylenetetraaminehexaacetic acid (TTHA), 1,3-diamino-2-hydroxypropane-N,N,N',N'-tetraacetic acid (DHPTA), methyliminodiacetic acid, propylenediaminetetraacetic acid, 1,5,9-triazacyclododecane-N,N',N''-tris(methylenephosphonic acid) (DOTRP), 1,4,7,10-tetraazacyclododecane-N,N',N'',N'''-tetrakis(methylenephosphonic acid), (DOTP), nitrilotris(methylene)triphosphonic acid, diethylenetriaminepenta(methylenephosphonic acid) (DETAP), aminotri(methylenephosphonic acid), 1-hydroxyethylene-1,1-diphosphonic acid, bis(hexamethylene)triamine phosphonic acid, 1,4,7-triazacyclononane-N,N',N''-tri(methylenephosphonic acid) (NOTP), 2-phosphonobutane-1,2,4-tricarboxylic acid, nitrilotriacetic acid (NTA), citric acid, tartaric acid, gluconic acid, saccharic acid, glyceric acid, oxalic acid, phthalic acid, maleic acid, mandelic acid, malonic acid, lactic acid, salicylic acid, 5-sulfosalicylic acid, cysteine and acetylcysteine, gallic acid and their salts; catechol, , propyl gallate, pyrogallol and 8-hydroxyquinoline.

Additional examples of suitable metal chelating agents (G) are disclosed in the American application US 2010/0319735 A1, page 2, paragraphs [0039] to [0042] and page 7, paragraphs [0133] to [0143].

Most preferably, the metal chelating agent (G) contains at least one group having a pKa of 10 to 13 because such metal chelating agents have a high affinity for metal containing residues.

The concentration of the metal chelating agent (G) in the composition of the invention can vary broadly and, therefore, can be adjusted easily and precisely to the particular requirements of the relevant treatment method and manufacturing method of the invention. Preferably, the concentration is in the range of from the 0.001 to 5% by weight" more preferably 0.005 to 2.5% by weight and most preferably 0.01 to 2% by weight, the weight percentages being based on a complete weight of the composition of the invention.

Most preferably, the composition of the invention contains the components (A), (B), (C) and (G) and most particularly preferably (A), (B), (C), (D), (F) and (G) in the above-mentioned preferred concentrations, the remainder being water in each case.

The preparation of the composition of the invention does not offer any particularities but can be carried out preferably by adding the above described essential components (A), (B) and (C) and the optional components (D), (E), (F) and/or (G) to water in concentrations which may be higher than the concentrations in the composition of the invention when used in the treatment method and the manufacturing methods of the invention. This way, a concentrate is prepared which can be handled and stored without problems and may be diluted further with water before its use in the treatment method and manufacturing methods of the invention. Preferably, the optional component (F) is added shortly before use.

Preferably, the pH of the composition of the invention is adjusted in the range from 8 to 13, most preferably 8.5 to 13.

For the preparation of the composition of the invention, customary and standard mixing processes and corrosion resistant mixing devices such as agitated vessels, in-line dissolvers, high shear impellers, ultrasonic mixers, homogenizer nozzles or counterflow mixers can be used.

The composition of the invention is excellently suited for the treatment of silicon substrates, in particular the treatment of silicon wafers.

According to the invention, the silicon wafers are used for manufacturing devices generating electricity upon exposure to electromagnetic radiation, in particular the manufacturing of photovoltaic cells and solar cells, especially of selective emitter solar cells, Passivated Emitter and Rear Cells (PERC), Metal Wrap Through (MWT) solar cells and Emitter Wrap Through (EWT) solar cells. Therefore, the electromagnetic radiation is preferably solar radiation.

According to the invention, the composition of the invention is most preferably used for the modification of the surface of the silicon substrates by etching and oxidation, the removal of silicate glass (SG) and dead layers generated by the emitter doping, the removal of porous silicon generated by the wet edge isolation and/or the removal of debris which has re-contaminated the surface of the silicon substrates.

The treatment method of the invention renders the surface of the silicon substrates, in particular the surface of silicon wafers, hydrophilic and/or modifies the surface of silicon substrates by etching and oxidation.

In the first step of the treatment method of the invention, an aqueous alkaline composition is provided, preferably by the methods described hereinbefore.

The aqueous alkaline composition comprises at least one quaternary ammonium hydroxide (A) as described hereinbefore.

It furthermore comprises at least one component (B) selected from the group consisting of

(b1 a) water-soluble sulfonic acids and their water-soluble salts of the general formula I:

$$(R-SO_3^-)_n X^{n+} \qquad (Ia),$$

(b2) water-soluble phosphonic acids and their water-soluble salts of the general formula II:

$$R-PO_3^{2-}(X^{n+})_{3-n} \qquad (II),$$

(b3) water-soluble sulfuric acid esters and their water-soluble salts of the general formula III:

$$(RO-SO_3^-)_n X^{n+} \qquad (III),$$

(b4) water-soluble phosphoric acid esters and their water-soluble salts of the general formula (IV):

$$RO-PO_3^{2-} (X^{n+})_{3-n} \qquad (IV),$$

and

(b5) water-soluble phosphoric acid esters and their water-soluble salts of the general formula (V):

$$[-(RO)_2PO_2^-]_n X^{n+} \qquad (V);$$

wherein the index n = 1 or 2; the variable X is selected from the group consisting of hydrogen, ammonium, alkaline metal and alkaline-earth metal; and the variable R is selected from the group consisting of

- aliphatic moieties having 2 to 5, preferably 2 to 4 and most preferably 2 or 3 carbon atoms and at least one, preferably one olefinically unsaturated double bond;

- cycloaliphatic moieties having 4 to 6, preferably 5 or 6 and most preferably 6 carbon atoms and at least one, preferably one olefinically unsaturated double bond; and

- alkylaryl moieties, wherein the aryl moieties are selected from benzene and naphthalene, preferably benzene, and the alkyl moieties are selected from methylene, ethane-diyl and propane-diyl, preferably ethane-diyl:

The sulfur atom and the phosphorus atom in the general formulas Ia and II are each bonded directly to an aliphatic carbon atom. The sulfur atom in the general formula III and the phosphorus atom in the general formulas IV and V are each bonded via an oxygen atom to an aliphatic carbon atom.

Preferably, the variable R is selected from the group consisting of the moieties R as described hereinbefore.

Most preferably, the component (B) is selected from the group consisting of the aforementioned most preferably used water-soluble acids and their water-soluble salts (b1), (b2), (b3), (b4) and (b5) and benzylsulfonic acid and its salts.

Moreover, the aqueous alkaline composition contains a buffer system (C), preferably ammonium carbonate (C).

More preferably, the aqueous alkaline composition furthermore contains the optional components (D), (E) (F) and/or (G).

Most preferably the essential and optional components are used in the amounts hereinbefore described.

In the second step of the treatment method of the invention, one of the major surfaces or the two opposing major surfaces of the silicon substrate, preferably of the silicon wafer, is or are contacted at least once with the aqueous alkaline composition for a time, preferably 30 seconds to 10 minutes, and at a temperature, preferably 20°C to 60°C, which are sufficient to obtain a clean hydrophilic surface or two clean hydrophilic surfaces.

This can be accomplished, for example, by dipping at least one silicon substrate, in particular at least one silicon wafer, in its entirety either horizontally or vertically in a tank filled with the aqueous alkaline composition or by conveying at least one silicon substrate, preferably by a system of conveyor rolls, essentially horizontally through a tank filled with the said composition.

In the third step of the treatment method of the invention, the at least one major surface is removed from the contact with the aqueous alkaline composition

The composition and the treatment method of the invention can be advantageously used in manufacturing processes of various semiconductor devices. Most preferably, they are used in the manufacturing methods of the invention.

The first and second manufacturing methods of the invention yield semiconductor devices, in particular photovoltaic or solar cells, which are capable of generating electricity upon exposure to electromagnetic radiation, in particular solar light.

The first step of the first and second manufacturing methods of the invention is preceded by process steps customary and known in the art of manufacturing solar cells.

In the first step of the first and second manufacturing methods of the invention, at least one major surface of a silicon substrate, preferably a silicon wafer, is textured with an etching composition which is known in the art. This way, a hydrophobic surface is obtained.

The first step may be followed by neutralizing, rinsing and drying steps.

In a subsequent step of the first manufacturing method of the invention, at least one major surface of the said substrate may be subjected to the treatment method of the invention as described hereinbefore in detail. This way, the former hydrophobic surface or surfaces is or are converted into a hydrophilic surface or into hydrophilic surfaces.

Such a step may also be followed by rinsing and drying steps.

In the following step of the first manufacturing method of the invention, at least one, preferably one, spray-on emitter source, is applied onto the hydrophilic surface or surfaces.

Preferably, a liquid phosphorus emitter source such as phosphoric acid or a liquid boron emitter source such as boric acid is used. More preferably a liquid phosphorus emitter source, in particular diluted aqueous or alcoholic phosphoric acid is used.

Thereafter, in the subsequent step of the first manufacturing method of the invention, the surface or the surfaces of the silicon substrate contacted with the emitter source is or are heated, for example, in an infrared heated belt furnace, thereby forming the emitters, preferably the boron or phosphorus emitters, more preferably the phosphorus emitters within the silicon substrate. A silicate glass (SG) layer, preferably a boron silicate glass (BSG) layer or a phosphorus silicate glass (PSG) layer, most preferably a PSG layer may also be formed on top of the surface or the surfaces of the silicon substrate in this process step.

In the following step of the first manufacturing method of the invention, the SG layer if present is removed from the surface or the surfaces of the silicon substrate, preferably by a hydrofluoric acid treatment.

This optional step may be followed by neutralizing, rinsing and drying steps.

In the subsequent step of the first manufacturing method of the invention, the upper layer of the silicon substrate material containing the emitters is modified. Most preferably, the modification is accomplished by the treatment method of the invention.

Again, this step may be followed by rinsing and drying steps.

In a following step of the first manufacturing method of the invention, at least one major surface of the said substrate may be subjected to the treatment method of the invention as described hereinbefore in detail. This way, the former hydrophobic surface or surfaces is or are converted into a hydrophilic surface or into hydrophilic surfaces.

Such a step may also be followed by rinsing and drying steps.

In the subsequent step of the first manufacturing method of the invention, an anti-reflective layer is deposited on top of the modified upper layer of the silicon substrate containing the emitters, thereby obtaining an intermediate for further processing.

It is essential for the first manufacturing method of the invention that at least one step of hydrophilizing the hydrophobic surface is carried out. Such a hydrophilizing step may be carried out after the first process step before the spray-on emitter source is applied. The hydrophilizing step may also be carried out after after the modification of the upper layer of the silicon substrate before the antireflective layer is applied. However, both hydrophilizing steps may be carried out in the course of the first manufacturing method of the invention.

In the further course of the first manufacturing method of the invention, the intermediate is further processed by way of process steps customary and known in the art of manufacturing solar cells thus yielding devices, in particular photovoltaic and solar cells, in exceptionally high yields, which devices generate electricity upon the exposure to electromagnetic radiation and have high efficiencies and a uniform appearance.

In the second manufacturing method of the invention, the hydrophobic surface of the silicon substrate is treated in a heated atmosphere containing at least one gaseous emitter source, preferably a boron emitter source or a phosphorus emitter source, more preferably a phosphorus emitter source, thereby forming emitters, preferably boron or phosphorus emitters, more preferably phosphorus emitters, within the silicon substrate or emitters, preferably boron or phosphorus emitters, more preferably phosphorus emitters, within the silicon substrate and a silicate glass (SG), preferably a BSG or a PSG, more preferably a PSG, on top of the surface of the silicon substrate.

Examples of suitable gaseous boron emitter sources are boron halides, in particular boron trifluoride, boron trichloride and boron tribromide.

An example for suitable gaseous phosphorus emitter sources is $POCl_3$.

Preferably, the heat treatment is carried out in a diffusion furnace, in particular a tube furnace for diffusion applications. To this end, the silicon substrates are mounted vertically in a quartz boat holder, then inserted batchwise into the furnace and then subjected to a batchwise treatment.

Thereafter, in the next step of the second manufacturing method of the invention, the surface or the surfaces of the silicon substrate contacted with the gaseous emitter source is or are heated, for example, in an infrared heated belt furnace,

In the next step of the second manufacturing method of the invention, the SG layer if present is removed from the silicon substrate surface or surfaces, preferably by a hydrofluoric acid treatment.

This optional step may be followed by neutralizing, rinsing and drying steps.

In the next step of the second manufacturing method of the invention, the upper layer of the silicon substrate containing the emitters is modified. Most preferably, the modification is accomplished by the treatment method of the invention.

Again, this step may be followed by rinsing and drying steps.

In the next step of the second manufacturing method of the invention, an anti-reflective layer is deposited on top of the modified upper layer of the silicon substrate containing the emitters, thereby obtaining an intermediate for further processing.

In the further course of the second manufacturing method of the invention, the intermediate is further processed by way of process steps customary and known in the art of manufacturing solar cells thus yielding devices, in particular photovoltaic and solar cells, especially selected emitters solar cells in exceptionally high yields, which devices generate electricity upon the exposure to electromagnetic radiation and have high efficiencies and a uniform appearance.

Both, in the first and second manufacturing methods of the invention, a wet edge isolation step can be carried out before an anti-reflective layer is deposited on top of the modified semiconductor material containing the emitters. Thereafter, porous silicon generated by the wet edge isolation and re-contaminating debris can be removed by the treatment method of the invention. This way, the applicational properties of the photovoltaic cells and the solar cells, especially of the selective emitter solar cells, Passivated Emitter and Rear Cells (PERC), Metal Wrap Through (MWT) solar cells and Emitter Wrap Through (EWT) solar cells, are further improved.

Examples

Examples 1 to 4

The pH Stability of the Aqueous Alkaline Compositions 1 to 4 of the Examples 1 to 4 Containing Ammonium Carbonate or Sodium Carbonate and of the Aqueous Alkaline Composition C1 of the Comparative Example C1

For the Examples 1 to 4 and the Comparative Example C1, the respective aqueous alkaline compositions were prepared by dissolving their components in ultrapure water. The relevant compositions 1 to 4 and C1 are listed in the Table 1. The pH values were adjusted by varying the buffer components and their amounts. The percentages are weight percentages based on the complete weight of the compositions.

Table 1: The Composition of the Aqueous Alkaline Compositions 1 to 4 of the Examples 1 to 4 and of the Aqueous Alkaline Composition C1 of the Comparative Example C1

| Ex.[a] | C1 | 1 | 2 | 3 | 4 |
|---|---|---|---|---|---|
| Water /% | 64.2 | 63.7 | 63.9 | 72.7 | 71.2 |
| TEAH[b]/% | 25 | 25 | 25 | 20 | 20 |
| HAc[c]//% | 1 | 1 | 1 | 1 | 1 |
| HCl[d]/% | 3.7 | 3.7 | 3.7 | - | - |

(continued)

| Ex.[a) | C1 | 1 | 2 | 3 | 4 |
|---|---|---|---|---|---|
| NH$_3$[e)/% | 2 | 2 | 2 | 2.3 | - |
| 1-aminoethanol/% | 2 | - | - | - | - |
| Sodium Carbonate[f)/% | - | 2.5 | - | - | - |
| Ammonium Carbonate[f)/% | - | - | 2.3 | 2 | 5.8 |
| Sulfonic Acid (B)/% | 0.6 | 0.6 | 0.6 | 0.5 | 0.5 |
| Metal Chelating Agent (G)/% | 1.5 | 1.5 | 1.5 | 1.5 | 1.5 |
| pH[f) Bath Lifetime = 5 min | 8.7 | 9 | 8.55 | 8.65 | 8.55 |
| pH[f) Bath Lifetime = 400 min | 7.55 | 9.4 | 8.3 | 8.6 | 8.3 |
| a) Ex. = Example or Comparative Example; b) TEAH = tetraethylammonium hydroxide (20% in water); c) HAc = acetic acid (100%); d) HCl, 36% in water; e) ammonia, 28% in water; f) solids; g) pH at 65°C | | | | | |

The data of the Table 1 show that it is possible to tune the pH behavior of the baths over the bath lifetime from a slight decrease or increase of the pH to a nearly constant pH level simply by varying the buffer system and/or varying the amounts of its components.

For the wetting experiments, i.e., the determination of the hydrophilizing efficiency, 1 part by weight of the composition 3 of Example 3 was diluted with 6 parts by weight of ultrapure water and 1 part by weight of hydrogen peroxide (31% by weight in water) so that an aqueous alkaline composition having a hydrogen peroxide content of 3.87% by weight based on the complete weight of the composition was obtained.

The hydrophilizing efficiencies of the said diluted composition and of water was determined as follows.

A silicon wafer piece having a surface rendered hydrophobic by a hydrofluoric acid treatment was dipped into water and into the obtained composition at 40°C for 2 minutes. Thereafter, the silicon wafer piece was rinsed and dried.

Six 200 μl droplets of phosphoric acid (2% by weight in alcohol were dripped onto the surface of the dried silicon wafer piece. The area of each of the six spread droplets were measured by software supported photographic image processing after 5 minutes spreading time. The corrected average area value and the corrected standard deviation were calculated in each case. For purposes of clearness, the obtained average area values were compared with the area of a 1 Euro coin as reference, the area of which was defined to be 100%. The hydrophilizing efficiency (HE) was determined from the ratio

$$\text{Area Drop / Area Coin x 100.}$$

The HE increase as compared to only water was in the range of 100%

The diluted composition 3 of the Example 3 was particularly stable. In particular, due to the excellent buffering capacity, the pH of the said diluted composition did not change upon increasing the acid concentration in a wide range. Therefore, the HE remained stable under the conditions of an industrial process for manufacturing photovoltaic or solar cells. Moreover, it yielded smooth etched surfaces having an advantageous micro-roughness. Furthermore, the etching and cleaning results were reproducible in an excellent manner. Last but not least, it was excellently suited as wet cleaning and modification composition in the additional wet cleaning and modification step carried out after the PSG removal. The metal cleaning efficiency was proven by secondary ion mass spectrometry surface analysis (SIMS). The cleaning results were outstanding even at reduced temperatures (45°C). In particular, the iron contamination of the silicon wafer surfaces could be significantly reduced.

**Example 5**

**The Pilot Plant Scale Production of Solar Cells Employing the Diluted Composition 3 of the Example 3**
Solar cells were produced in a pilot plant scale production line. In the relevant process steps, wherein the diluted composition 3 of the Example 3 was employed, the silicon wafers were conveyed horizontally through the etching and cleaning baths by way of alkaline stable conveyer rolls.
The relevant surfaces of the silicon wafers were textured with an aqueous acidic etching composition containing hydrofluoric acid. This way, hydrophobic surfaces were obtained. Thereafter, the hydrophobic silicon wafers were neutralized, rinsed and dried.
Thereafter, the hydrophobic silicon wafers were conveyed through a bath containing the diluted composition 3 of the Example 3 at 40°C at a conveying speed that each silicon wafer was contacted with the diluted composition for 2 minutes. This way, the former hydrophobic surfaces of the wafers were converted into hydrophilic surfaces. Thereafter, the silicon wafers were rinsed and dried.
In the following step, phosphoric acid (2% by weight in water) was applied as the liquid phosphorus emitter source onto the hydrophilic surfaces of the silicon wafers.
Thereafter, the surfaces of the silicon wafers coated with the liquid emitter source were heated, thereby forming the phosphorus emitters within the silicon substrate material and a PSG layer on top of the silicon wafer surfaces.
Then, the PSG layers were removed from the surface of the silicon wafers by a 10% hydrofluoric acid treatment. Thereafter, the silicon wafers were neutralized, rinsed and dried.
In the following step, the relevant surfaces of each silicon wafer were cleaned from PSG residues and modified by treating the wafers with the diluted composition 3 of the Example 3 at about 50°C for 2 minutes. Thereafter, the silicon wafers were treated with a 1 % hydrofluoric acid, rinsed and dried.
A hydrogen doped silicon nitride layer was then applied on top of one of the modified surfaces of the silicon wafers as a passivating and antireflective layer by physically enhanced chemical vapor deposition (PECVD) to obtain intermediates.
Thereafter, the intermediates were further processed by way of process steps customary and known in the art of manufacturing solar cells thus yielding solar cells having high efficiencies and a uniform appearance in high yields
The determination of the electrical characteristics of the solar cells thus obtained gave superior results indicating cell efficiency gains in the range of 0,1-0,4% as compared with the efficiencies of solar cells produced by prior art processes.

**Example 6**

**The Pilot Plant Scale Production of Solar Cells Employing the Diluted Composition 3 of the Example 3**
Solar cells were produced in a pilot plant scale production line. In the relevant process step, wherein the diluted composition 3 of the Example 3 was employed, the silicon wafers were conveyed horizontally through the etching and cleaning baths by way of alkaline stable conveyer rolls.
The relevant surfaces of the silicon wafers were textured with an aqueous acidic etching composition containing hydrofluoric acid. This way, hydrophobic surfaces were obtained. Thereafter, the hydrophobic silicon wafers were neutralized, rinsed and dried.
The relevant hydrophobic surfaces of the silicon wafers were treated in a heated atmosphere containing $POCl_3$, thereby forming phosphorus emitters within the silicon wafers and a phosphorus silicate glass on top of the surfaces of the silicon wafers;
Thereafter, the PSG layers were removed from the surfaces of the silicon wafers by a 10% hydrofluoric acid treatment. Thereafter, the silicon wafers were neutralized, rinsed and dried.
In the following step, the relevant surfaces of each silicon wafer were cleaned from PSG residues and modified by treating the wafers with the diluted composition 3 of the Example 3 at about 50°C for 2 minutes. Thereafter, the silicon wafers were treated with a 1% hydrofluoric acid, rinsed and dried.
A hydrogen doped silicon nitride layer was then applied on top of one of the modified surfaces of the silicon wafers as a passivating and antireflective layer by physically enhanced chemical vapor deposition (PECVD) to obtain intermediates.
Thereafter, the intermediates were further processed by way of process steps customary and known in the art of manufacturing solar cells thus yielding solar cells having high efficiencies and a uniform appearance in high yields
The determination of the electrical characteristics of the solar cells thus obtained gave superior results indicating cell efficiency gains in the range of 0,1-0,4% as compared with the efficiencies of solar cells produced by prior art processes.

**Claims**

1. An aqueous alkaline composition comprising:

(A) at least one quaternary ammonium hydroxide;
(B) at least one component selected from the group consisting of

(b1) water-soluble sulfonic acids and their water-soluble salts of the general formula I:

$$(R^1\text{-}SO_3^-)_n X^{n+} \qquad (I),$$

(b2) water-soluble phosphonic acids and their water-soluble salts of the general formula II:

$$R\text{-}PO_3^{2-}(X^{n+})_{3-n} \qquad (II);$$

(b3) water-soluble sulfuric acid esters and their water-soluble salts of the general formula III:

$$(RO\text{-}SO_3^-)_n(^{n+} \qquad (III),$$

(b4) water-soluble phosphoric acid esters and their water-soluble salts of the general formula (IV):

$$RO\text{-}PO_3^{2-}(X^{n+})_{3-n} \qquad (IV),$$

and
(b5) water-soluble phosphoric acid esters and their water-soluble salts of the general formula (V):

$$[(RO)_2PO_2^-]_n X^{n+} \qquad (V);$$

wherein the index n = 1 or 2; the variable X is selected from the group consisting of hydrogen, ammonium, alkaline metal and alkaline-earth metal; the variable $R^1$ is selected from the group consisting of aliphatic moieties having 2 to 5 carbon atoms and at least one olefinically unsaturated double bond, and cycloaliphatic moieties having 4 to 6 carbon atoms and at least one olefinically unsaturated double bond; and the variable R is selected from the group consisting of aliphatic moieties having 2 to 5 carbon atoms and at least one olefinically unsaturated double bond, cycloaliphatic moieties having 4 to 6 carbon atoms and at least one olefinically unsaturated double bond, and alkylaryl moieties, wherein the aryl moieties are selected from benzene and naphthalene, the alkyl moieties are selected from methylene, ethane-diyl and propane-diyl, and the phosphorus atom in the general formula II is bonded directly and the sulfur atom in the general formula III and the phosphorus atom in the general formulas IV and V are each bonded via an oxygen atom to an aliphatic carbon atom; and
(C) a buffer system, wherein at least one component other than water is volatile.

2. The composition according to claim 1, **characterized in that** the buffer system (C) is selected from the group consisting of alkali metal carbonates, alkali metal carbonates/ammonia, alkali metal acetates, alkali metal acetates/ammonia, ammonium acetate, ammonium acetate/ammonia, Ammonium carbonate and ammonium carbonate/ammonia.

3. The composition according to claim 1 or 2, **characterized in that** it contains at least one component selected from the group consisting of acids (D), bases (E), oxidizing agents (F), and metal chelating agents (G).

4. A method for treating the surface of a silicon substrate comprising the steps of:

(1) providing an aqueous alkaline composition comprising

(A) at least one quaternary ammonium hydroxide;
(B) at least one component selected from the group consisting of

(b1a) water-soluble sulfonic acids and their water-soluble salts of the general formula I:

$$(R\text{-}SO_3^-)_nX^{n+} \qquad (Ia),$$

(b2) water-soluble phosphonic acids and their water-soluble salts of the general formula II:

$$R\text{-}PO_3^2\,(X^{n+})_{3-n} \qquad (II),$$

(b3) water-soluble sulfuric acid esters and their water-soluble salts of the general formula III:

$$(RO\text{-}SO_3^-)_nX^{n+} \qquad (III),$$

(b4) water-soluble phosphoric acid esters and their water-soluble salts of the general formula (IV):

$$RO\text{-}PO_3^{2-}(X^{n+})_{3-n} \qquad (IV),$$

and
(b5) water-soluble phosphoric acid esters and their water-soluble salts of the general formula (V):

$$[(RO)_2PO_2^-]_nX^{n+} \qquad (V);$$

wherein the index n = 1 or 2; the variable X is selected from the group consisting of hydrogen, ammonium, alkaline metal and alkaline-earth metal; and the variable R is selected from the group consisting of aliphatic moieties having 2 to 5 carbon atoms and at least one olefinically unsaturated double bond, cycloaliphatic moieties having 4 to 6 carbon atoms and at least one olefinically unsaturated double bond, and alkylaryl moieties, wherein the aryl moieties are selected from benzene and naphthalene, the alkyl moieties are selected from methylene, ethane-diyl and propane-diyl, and the sulfur atom and the phosphorus atom in the general formulas Ia and II are each bonded directly and the sulfur atom in the general formula III and the phosphorus atom in the general formulas IV and V are each bonded via an oxygen atom to an aliphatic carbon atom; and

(C) a buffer system, wherein at least one component other than water is volatile;

(2) contacting at least one major surface of the silicon substrate at least once with the said aqueous alkaline composition for a time and at a temperature sufficient to obtain a clean hydrophilic surface; and
(3) removing the at least one major surface from the contact with the aqueous alkaline composition.

5. The method according to claim 4, **characterized in that** the buffer system (C) is selected from the group consisting of alkali metal carbonates, alkali metal carbonates/ammonia, alkali metal acetates, alkali metal acetates/ammonia, ammonium acetate, ammonium acetate/ammonia, ammonium carbonate and ammonium carbonate/ammonia.

6. The method according to claim 4 or 5, **characterized in that** the aqueous alkaline composition renders the modification of the surface of the silicon substrates by etching and oxidation, the removal of silicate glass and dead layers generated by the emitter doping, the removal of porous silicon generated by the wet edge isolation and/or the removal of debris which has re-contaminated the surface of the silicon substrates.

7. A method for manufacturing devices generating electricity upon the exposure to electromagnetic radiation comprising the steps of

(1.I) texturing at least one major surface of a silicon substrate with an etching composition, thereby generating a hydrophobic surface;
(I.II) hydrophilizing the hydrophobic surface by employing the method for treating the surface of the silicon substrate according to anyone of the claims 4 to 6;
(9.III) applying at least one spray-on emitter source onto the hydrophilic surface;
(1.IV) heating the silicon substrate contacted with the emitter source, thereby forming emitters within the silicon substrate or emitters within the silicon substrate and a silicate glass on top of the surface of the silicon substrate;
(1.V) modifying the upper layer of the silicon substrate containing the emitters or removing the silicate glass from the surface of the silicon semiconductor and, thereafter, modifying the upper layer of the silicon substrate containing the emitters, thereby obtaining a hydrophobic surface;
(1.VI) hydrophilizing the hydrophobic surface by employing the method for treating the surface of the silicon substrate according to anyone of the claims 4 to 6;

(1.VII) depositing an antireflective layer on top of the modified upper layer of the silicon substrate containing the emitters, thereby obtaining an intermediate; and

(1.VIII) further processing the intermediate to obtain the device;

with the proviso that either the process step (1.II) or the process step (1.VI) is carried out or that both process steps (1.II) and (1.VI) are carried out.

8. The manufacturing method according to claim 7, **characterized in that** a wet edge isolation step is carried out before the process step (1.VI).

9. The manufacturing method according to claim 8, **characterized in that** the method for treating the surface of a silicon substrate according to anyone of the claims 4 to 6 is carried out after the wet edge isolation step.

10. The manufacturing method according to anyone of the claims 7 to 9, **characterized in that** the devices are photovoltaic cells and solar cells.

11. A method for manufacturing devices generating electricity upon the exposure to electromagnetic radiation comprising the steps of

(2.I) texturing at least one major surface of a silicon substrate with an etching composition, thereby generating a hydrophobic surface;

(2.II) treating the hydrophobic surface of the silicon substrate in a heated atmosphere containing at least one gaseous emitter source, thereby forming emitters within the silicon substrate or emitters within the silicon substrate and a silicate glass on top of the surface of the silicon substrate;

(2.III) modifying the upper layer of the silicon substrate containing the emitters or removing the silicate glass from the surface of the silicon semiconductor and, thereafter, modifying the upper layer of the silicon substrate containing the emitters by the method for treating the surface of a silicon substrate according to anyone of the claims 4 to 6;

(2.IV) depositing an antireflective layer on top of the modified upper layer of the silicon substrate containing the emitters, thereby obtaining an intermediate; and

(2.V) further processing the intermediate to obtain the device.

12. The manufacturing method according to claim 11, **characterized in that** a wet edge isolation step is carried out before the process step (2.IV).

13. The manufacturing method according to claim 12, **characterized in that** the method for treating the surface of a silicon substrate according to anyone of the claims 4 to 6 is carried out after the wet edge isolation step.

14. The manufacturing method according to anyone of the claims 11 to 13, **characterized in that** the devices are photovoltaic cells and solar cells.

15. The use of a buffer system, wherein at least one component other than water is volatile for stabilizing the pH of aqueous alkaline compositions containing

(A) at least one quaternary ammonium hydroxide; and

(B) at least one component selected from the group consisting of

(b1a) water-soluble sulfonic acids and their water-soluble salts of the general formula I:

$$(R\text{-}SO_3^-)_n X^{n+} \qquad (Ia),$$

(b2) water-soluble phosphonic acids and their water-soluble salts of the general formula II:

$$R\text{-}PO_3^{2-}(X^{n+})_{3-n} \qquad (II),$$

(b3) water-soluble sulfuric acid esters and their water-soluble salts of the general formula III:

$$(RO\text{-}SO_3^-)_n X^{n+} \qquad (III),$$

(b4) water-soluble phosphoric acid esters and their water-soluble salts of the general formula (IV):

$$RO=PO_3^{2-} (X^{n+})_{3-n} \qquad (IV),$$

and

(b5) water-soluble phosphoric acid esters and their water-soluble salts of the general formula (V):

$$[(RO)_2PO_2^-]_n X^{n+} \qquad (V);$$

wherein the index n = 1 or 2; the variable X is selected from the group consisting of hydrogen, ammonium, alkaline metal and alkaline-earth metal; and the variable R is selected from the group consisting of aliphatic moieties having 2 to 5 carbon atoms and at least one olefinically unsaturated double bond, cycloaliphatic moieties having 4 to 6 carbon atoms and at least one olefinically unsaturated double bond, and alkylaryl moieties, wherein the aryl moieties are selected from benzene and naphthalene, the alkyl moieties are selected from methylene, ethane-diyl and propane-diyl, and the sulfur atom and the phosphorus atom in the general formulas Ia and II are each bonded directly and the sulfur atom in the general formula III and the phosphorus atom in the general formulas IV and V are each bonded via an oxygen atom to an aliphatic carbon atom.

**Patentansprüche**

1. Wässrige basische Zusammensetzung, umfassend:

(A) wenigstens ein quaternäres Ammoniumhydroxid;
(B) wenigstens eine Komponente ausgewählt aus der Gruppe bestehend aus

(b1) wasserlöslichen Sulfonsäuren und ihren wasserlöslichen Salzen der allgemeinen Formel I:

$$(R^1\text{-}SO_3^-)_n X^{n+} \qquad (I),$$

(b2) wasserlöslichen Phosphonsäuren und ihren wasserlöslichen Salzen der allgemeinen Formel II:

$$R\text{-}PO_3^{2-}(X^{n+})_{3-n} \qquad (III),$$

(b3) wasserlöslichen Schwefelsäureestern und ihren wasserlöslichen Salzen der allgemeinen Formel III:

$$(RO\text{-}SO_3^-)_n X^{n+} \qquad (III),$$

(b4) wasserlöslichen Phosphorsäureestern und ihren wasserlöslichen Salzen der allgemeinen Formel (IV):

$$RO\text{-}PO_3^{2-}(X^{n+})_{3-n} \qquad (IV)$$

und

(b5) wasserlöslichen Phosphorsäureestern und ihren wasserlöslichen Salzen der allgemeinen Formel (V):

$$[(RO)_2PO_2^-]_n X^{n+} \qquad (V);$$

wobei der Index n = 1 oder 2; die Variable X ausgewählt ist aus der Gruppe bestehend aus Wasserstoff, Ammonium, Alkalimetall und Erdalkalimetall; die Variable $R^1$ ausgewählt ist aus der Gruppe bestehend aus aliphatischen Einheiten mit 2 bis 5 Kohlenstoffatomen und wenigstens einer olefinisch ungesättigten Doppelbindung und cycloaliphatischen Einheiten mit 4 bis 6 Kohlenstoffatomen und wenigstens einer olefinisch ungesättigten Doppelbindung; und die Variable R ausgewählt ist aus der Gruppe bestehend aus aliphatischen Einheiten mit 2 bis 5 Kohlenstoffatomen und wenigstens einer olefinisch ungesättigten Doppelbindung, cycloaliphatischen Einheiten mit 4 bis 6 Kohlenstoffatomen und wenigstens einer olefinisch ungesättigten Doppelbindung und Alkylaryleinheiten, wobei die Aryleinheiten ausgewählt sind aus Benzol und Naphthalin, die Alkyleinheiten ausgewählt sind aus Methylen, Ethandiyl und Propandiyl, und das Phosphoratom in der allgemeinen Formel II direkt und das Schwefelatom in der allgemeinen Formel III und das Phosphoratom in den allgemeinen Formeln IV und V jeweils über ein Sauerstoffatom an ein aliphatisches Kohlenstoffatom gebunden sind; und
(C) ein Puffersystem, wobei wenigstens eine von Wasser verschiedene Komponente flüchtig ist.

2. Zusammensetzung gemäß Anspruch 1, **dadurch gekennzeichnet, dass** das Puffersystem (C) ausgewählt ist aus der Gruppe bestehend aus Alkalimetallcarbonaten, Alkalimetallcarbonaten/Ammoniak, Alkalimetallacetaten, Alkalimetallacetaten/Ammoniak, Ammoniumacetat, Ammoniumacetat/Ammoniak, Ammoniumcarbonat und Ammoniumcarbonat/Ammoniak.

3. Zusammensetzung gemäß Anspruch 1 oder 2, **dadurch gekennzeichnet, dass** sie wenigstens eine Komponente ausgewählt aus der Gruppe bestehend aus Säuren (D), Basen (E), Oxidationsmitteln (F) und Metallchelatbildnern (G) enthält.

4. Verfahren zum Behandeln der Oberfläche eines Siliciumsubstrats, umfassend die Schritte:

(1) Bereitstellen einer wässrigen basischen Zusammensetzung, umfassend

(A) wenigstens ein quaternäres Ammoniumhydroxid;
(B) wenigstens eine Komponente ausgewählt aus der Gruppe bestehend aus

(b1a) wasserlöslichen Sulfonsäuren und ihren wasserlöslichen Salzen der allgemeinen Formel I:

$$(R\text{-}SO_3^-)_n X^{n+} \qquad (Ia),$$

(b2) wasserlöslichen Phosphonsäuren und ihren wasserlöslichen Salzen der allgemeinen Formel II:

$$R\text{-}PO_3^{2-}(X^{n+})_{3-n} \qquad (III),$$

(b3) wasserlöslichen Schwefelsäureestern und ihren wasserlöslichen Salzen der allgemeinen Formel III:

$$(RO\text{-}SO_3^-)_n X^{n+} \qquad (III),$$

(b4) wasserlöslichen Phosphorsäureestern und ihren wasserlöslichen Salzen der allgemeinen Formel (IV):

$$RO\text{-}PO_3^{2-}(X)_{3-n} \qquad (IV)$$

und
(b5) wasserlöslichen Phosphorsäureestern und ihren wasserlöslichen Salzen der allgemeinen Formel (V):

$$[(RO)_2PO_2^-]_n X^{n+} \qquad (V);$$

wobei der Index n = 1 oder 2; die Variable X ausgewählt ist aus der Gruppe bestehend aus Wasserstoff, Ammonium, Alkalimetall und Erdalkalimetall; und die Variable R ausgewählt ist aus der Gruppe bestehend aus aliphatischen Einheiten mit 2 bis 5 Kohlenstoffatomen und wenigstens einer olefinisch ungesättigten Doppelbindung, cycloaliphatischen Einheiten mit 4 bis 6 Kohlenstoffatomen und wenigstens einer olefinisch ungesättigten Doppelbindung und Alkylaryleinheiten, wobei die Aryleinheiten ausgewählt sind aus Benzol und Naphthalin, die Alkyleinheiten ausgewählt sind aus Methylen, Ethandiyl und Propandiyl, und das Schwefelatom und das Phosphoratom in den allgemeinen Formeln Ia und II jeweils direkt und das Schwefelatom in der allgemeinen Formel III und das Phosphoratom in den allgemeinen Formeln IV und V jeweils über ein Sauerstoffatom an ein aliphatisches Kohlenstoffatom gebunden sind; und
(C) ein Puffersystem, wobei wenigstens eine von Wasser verschiedene Komponente flüchtig ist;

(2) wenigstens einmal Inkontaktbringen von wenigstens einer Hauptoberfläche des Siliciumsubstrats mit der wässrigen basischen Zusammensetzung für eine Zeit und bei einer Temperatur, die ausreichen, um eine saubere hydrophile Oberfläche zu erhalten; und

(3) Entfernen der wenigstens einen Hauptoberfläche aus dem Kontakt mit der wässrigen basischen Zusammensetzung.

5. Verfahren gemäß Anspruch 4, **dadurch gekennzeichnet, dass** das Puffersystem (C) ausgewählt ist aus der Gruppe bestehend aus Alkalimetallcarbonaten, Alkalimetallcarbonaten/Ammoniak, Alkalimetallacetaten, Alkalimetallacetaten/Ammoniak, Ammoniumacetat, Ammoniumacetat/Ammoniak, Ammoniumcarbonat und Ammoniumcarbonat/Ammoniak.

6. Verfahren gemäß Anspruch 4 oder 5, **dadurch gekennzeichnet, dass** die wässrige basische Zusammensetzung die Modifikation der Oberfläche der Siliciumsubstrate durch Ätzen und Oxidation, Entfernen von Silicatglas und toten Schichten, die durch die Emitterdotierung erzeugt sind, Entfernen von porösem Silicium, das durch nasse Kantenisolation erzeugt ist, und/oder Entfernen von Trümmern, die die Oberfläche der Siliciumsubstrate rekontaminiert hatten, ausführt.

7. Verfahren zum Herstellen von Einheiten, die bei Exposition gegenüber elektromagnetischer Strahlung Elektrizität erzeugen, umfassend die Schritte

(1.I) Texturieren von wenigstens einer Hauptoberfläche eines Siliciumsubstrats mit einer Ätzzusammensetzung, um so eine hydrophobe Oberfläche zu erzeugen;

(1.II) Hydrophilisieren der hydrophoben Oberfläche durch Einsatz des Verfahrens zum Behandeln der Oberfläche des Siliciumsubstrats gemäß einem der Ansprüche 4 bis 6;

(1.III) Aufbringen wenigstens einer Aufsprüh-Emitterquelle auf die hydrophile Oberfläche;

(1.IV) Erhitzen des mit der Emitterquelle in Kontakt gebrachten Siliciumsubstrats, um so Emitter innerhalb des Siliciumsubstrats oder Emitter innerhalb des Siliciumsubstrats und eines Silicatglases auf der Oberfläche des Siliciumsubstrats zu bilden;

(1.V) Modifizieren der oberen Schicht des Siliciumsubstrats, das die Emitter enthält, oder Entfernen des Silicatglases von der Oberfläche des Siliciumhalbleiters und anschließend Modifizieren der oberen Schicht des Siliciumsubstrats, das die Emitter enthält, um so eine hydrophobe Oberfläche zu erhalten;

(1.VI) Hydrophilisieren der hydrophoben Oberfläche durch Einsatz des Verfahrens zum Behandeln der Oberfläche des Siliciumsubstrats gemäß einem der Ansprüche 4 bis 6;

(1.VII) Abscheiden einer Antireflexschicht auf der modifizierten oberen Schicht des Siliciumsubstrats, das die Emitter enthält, um so ein Intermediat zu erhalten; und

(1.VIII) weiteres Bearbeiten des Intermediats, um die Einheit zu erhalten;

mit der Maßgabe, dass entweder der Verfahrensschritt (1.II) oder der Verfahrensschritt (1.VI) ausgeführt wird oder dass beide Verfahrensschritte (1.II) und (1.VI) ausgeführt werden.

8. Herstellungsverfahren gemäß Anspruch 7, **dadurch gekennzeichnet, dass** vor dem Verfahrensschritt (1.VI) ein nasser Kantenisolationsschritt durchgeführt wird.

9. Herstellungsverfahren gemäß Anspruch 8, **dadurch gekennzeichnet, dass** das Verfahren zum Behandeln der Oberfläche eines Siliciumsubstrats gemäß einem der Ansprüche 4 bis 6 nach dem nassen Kantenisolationsschritt durchgeführt wird.

10. Herstellungsverfahren gemäß einem der Ansprüche 7 bis 9, **dadurch gekennzeichnet, dass** die Einheiten Photovoltaikzellen und Solarzellen sind.

11. Verfahren zum Herstellen von Einheiten, die bei Exposition gegenüber elektromagnetischer Strahlung Elektrizität erzeugen, umfassend die Schritte

(2.I) Texturieren von wenigstens einer Hauptoberfläche eines Siliciumsubstrats mit einer Ätzzusammensetzung, um so eine hydrophobe Oberfläche zu erzeugen;

(2.II) Behandeln der hydrophoben Oberfläche des Siliciumsubstrats in einer erhitzten Atmosphäre, die wenigstens eine gasförmige Emitterquelle enthält, um so Emitter innerhalb des Siliciumsubstrats oder Emitter innerhalb des Siliciumsubstrats und eines Silicatglases auf der Oberfläche des Siliciumsubstrats zu bilden;

(2.III) Modifizieren der oberen Schicht des Siliciumsubstrats, das die Emitter enthält, oder Entfernen des Silicatglases von der Oberfläche des Siliciumhalbleiters und anschließend Modifizieren der oberen Schicht des Siliciumsubstrats, das die Emitter enthält, durch das Verfahren zum Behandeln der Oberfläche eines Siliciumsubstrats gemäß einem der Ansprüche 4 bis 6;

(2.IV) Abscheiden einer Antireflexschicht auf der modifizierten oberen Schicht des Siliciumsubstrats, das die Emitter enthält, um so ein Intermediat zu erhalten; und

(2.V) weiteres Bearbeiten des Intermediats, um die Einheit zu erhalten.

12. Herstellungsverfahren gemäß Anspruch 11, **dadurch gekennzeichnet, dass** vor dem Verfahrensschritt (2.IV) ein nasser Kantenisolationsschritt durchgeführt wird.

13. Herstellungsverfahren gemäß Anspruch 12, **dadurch gekennzeichnet, dass** das Verfahren zum Behandeln der Oberfläche eines Siliciumsubstrats gemäß einem der Ansprüche 4 bis 6 nach dem nassen Kantenisolationsschritt durchgeführt wird.

14. Herstellungsverfahren gemäß einem der Ansprüche 11 bis 13, **dadurch gekennzeichnet, dass** die Einheiten Photovoltaikzellen und Solarzellen sind.

15. Verwendung eines Puffersystems, wobei wenigstens eine von Wasser verschiedene Komponente flüchtig ist, zum Stabilisieren des pH-Werts von wässrigen basischen Zusammensetzungen, umfassend

(A) wenigstens ein quaternäres Ammoniumhydroxid; und

(B) wenigstens eine Komponente ausgewählt aus der Gruppe bestehend aus

(b1a) wasserlöslichen Sulfonsäuren und ihren wasserlöslichen Salzen der allgemeinen Formel I:

$$(R\text{-}SO_3^-)_n X^{n+} \qquad (Ia),$$

(b2) wasserlöslichen Phosphonsäuren und ihren wasserlöslichen Salzen der allgemeinen Formel II:

$$R\text{-}PO_3^{2-}(X^{n+})_{3-n} \qquad (II),$$

(b3) wasserlöslichen Schwefelsäureestern und ihren wasserlöslichen Salzen der allgemeinen Formel III:

$$(RO\text{-}SO_3^-)_n X^{n+} \qquad (III),$$

(b4) wasserlöslichen Phosphorsäureestern und ihren wasserlöslichen Salzen der allgemeinen Formel (IV):

$$RO\text{-}PO_3^{2-}(X^{n+})_{3-n} \qquad (IV)$$

und

(b5) wasserlöslichen Phosphorsäureestern und ihren wasserlöslichen Salzen der allgemeinen Formel (V):

$$[(RO)_2 PO_2^-]_n X^{n+} \qquad (V);$$

wobei der Index n = 1 oder 2; die Variable X ausgewählt ist aus der Gruppe bestehend aus Wasserstoff, Ammonium, Alkalimetall und Erdalkalimetall; und die Variable R ausgewählt ist aus der Gruppe bestehend aus aliphatischen Einheiten mit 2 bis 5 Kohlenstoffatomen und wenigstens einer olefinisch ungesättigten Doppelbindung, cycloaliphatischen Einheiten mit 4 bis 6 Kohlenstoffatomen und wenigstens einer olefinisch ungesättigten Doppelbindung und Alkylaryleinheiten, wobei die Aryleinheiten ausgewählt sind aus Benzol und Naphthalin, die Alkyleinheiten ausgewählt sind aus Methylen, Ethandiyl und Propandiyl, und das Schwefelatom und das Phosphoratom in den allgemeinen Formeln Ia und II jeweils direkt und das Schwefelatom in der allgemeinen Formel III und das Phosphoratom in den allgemeinen Formeln IV und V jeweils über ein Sauerstoffatom an ein aliphatisches Kohlenstoffatom gebunden sind.

**Revendications**

1. Composition alcaline aqueuse comprenant :

(A) au moins un hydroxyde d'ammonium quaternaire
(B) au moins un composant choisi dans le groupe constitué de

(b1) acides sulfoniques hydrosolubles et leurs sels hydrosolubles de formule générale 1 :

$$(R^1\text{-}SO_3^-)_n X^{n+} \qquad (I),$$

(b2) acides phosphoniques hydrosolubles et leurs sels hydrosolubles de formule générale II :

$$R\text{-}PO_3^{2-}(X^{n+})_{3-n} \qquad (II),$$

(b3) esters d'acide sulfurique hydrosolubles et leurs sels hydrosolubles de formule générale III :

$$(RO\text{-}SO_3^-)_n X^{n+} \qquad (III),$$

(b4) esters d'acide phosphorique hydrosolubles et leurs sels hydrosolubles de formule générale (IV) :

$$RO\text{-}PO_3^{2-}(X^{n+})_{3-n} \qquad (IV),$$

et
(b5) esters d'acide phosphorique hydrosolubles et leurs sels hydrosolubles de formule générale (V) :

$$[(RO)_2 PO_2^-)_n X^{n+} \qquad (V) ;$$

où l'indice n = 1 ou 2 ; la variable X est choisie dans le groupe constitué d'hydrogène, ammonium, un métal alcalin et un métal alcalino-terreux ; la variable $R^1$ est choisie dans le groupe constitué de fragments aliphatiques ayant 2 à 5 atomes de carbone et au moins une double liaison à insaturation oléfinique, et de fragments cycloaliphatiques ayant 4 à 6 atomes de carbone et au moins une double liaison à insaturation oléfinique ; et la variable R est choisie dans le groupe constitué de fragments aliphatiques ayant 2 à 5 atomes de carbone et au moins une double liaison à insaturation oléfinique, de fragments cycloaliphatiques ayant 4 à 6 atomes de carbone et au moins une double liaison à insaturation oléfinique, et de fragments alkylaryle, dans lesquels les fragments aryle sont choisis parmi benzène et naphtalène, les fragments alkyle sont choisis parmi méthylène, éthanediyle et propanediyle, et l'atome de phosphore dans la formule générale II est directement lié et l'atome de soufre dans la formule générale III et l'atome de phosphore dans les formules générales IV et V sont chacun liés via un atome d'oxygène à un atome de carbone aliphatique ; et
(C) un système tampon, dans lequel au moins un composant autre que l'eau est volatil.

2. Composition selon la revendication 1, **caractérisée en ce que** le système tampon (C) est choisi dans le groupe constitué de carbonates de métal alcalin, carbonates de métal alcalin/ammoniaque, acétates de métal alcalin, acétates de métal alcalin/ammoniaque, acétate d'ammonium, acétate d'ammonium/ammoniaque, carbonate d'ammonium et carbonate d'ammonium/ammoniaque.

3. Composition selon la revendication 1 ou 2, **caractérisée en ce qu'**elle contient au moins un composant choisi dans le groupe constitué d'acides (D), de bases (E), d'agents oxydants (F), et d'agents chélateurs de métal (G).

4. Procédé pour traiter la surface d'un substrat de silicium comprenant les étapes de :

(1) fourniture d'une composition alcaline aqueuse comprenant

(A) au moins un hydroxyde d'ammonium quaternaire ;
(B) au moins un composant choisi dans le groupe constitué de

(b1a) acides sulfoniques hydrosolubles et leurs sels hydrosolubles de formule générale I :

$$(R\text{-}SO_3^-)_n X^{n+} \qquad (Ia),$$

(b2) acides phosphoniques hydrosolubles et leurs sels hydrosolubles de formule générale II :

$$R\text{-}PO_3^{2-}(X^{n+})_{3-n} \qquad (II),$$

(b3) esters d'acide sulfurique hydrosolubles et leurs sels hydrosolubles de formule générale III :

$$(RO\text{-}SO_3^-)_n X^{n+} \qquad (III),$$

(b4) esters d'acide phosphorique hydrosolubles et leurs sels hydrosolubles de formule générale (IV) :

$$RO\text{-}PO_3^{2-}(X^{n+})_{3-n} \qquad (IV),$$

et
(b5) esters d'acide phosphorique hydrosolubles et leurs sels hydrosolubles de formule générale (V) :

$$[(RO)_2 PO_2^-]_n X^{n+} \qquad (V);$$

où l'indice n = 1 ou 2 ; la variable X est choisie dans le groupe constitué d'hydrogène, ammonium, un métal alcalin et un métal alcalino-terreux ; et la variable R est choisie dans le groupe constitué de fragments aliphatiques ayant 2 à 5 atomes de carbone et au moins une double liaison à insaturation oléfinique, de fragments cycloaliphatiques ayant 4 à 6 atomes de carbone et au moins une double liaison à insaturation oléfinique, et de fragments alkylaryle, dans lesquels les fragments aryle sont choisis parmi benzène et naphtalène, les fragments alkyle sont choisis parmi méthylène, éthanediyle et propanediyle, et l'atome de soufre et l'atome de phosphore dans les formules générales Ia et II sont chacun directement liés et l'atome de soufre dans la formule générale III et l'atome de phosphore dans les formules générales IV et V sont chacun liés via un atome d'oxygène à un atome de carbone aliphatique ; et
(C) un système tampon, dans lequel au moins un composant autre que l'eau est volatil ;

(2) mise en contact d'au moins une surface majeure du substrat de silicium au moins une fois avec ladite composition alcaline aqueuse pendant un temps et à une température suffisants pour obtenir une surface hydrophile propre ; et
(3) retrait de l'au moins une surface majeure du contact avec la composition alcaline aqueuse.

5. Procédé selon la revendication 4, **caractérisé en ce que** le système tampon (C) est choisi dans le groupe constitué de carbonates de métal alcalin, carbonates de métal alcalin/ammoniaque, acétates de métal alcalin, acétates de métal alcalin/ammoniaque, acétate d'ammonium, acétate d'ammonium/ammoniaque, carbonate d'ammonium et carbonate d'ammonium/ammoniaque.

6. Procédé selon la revendication 4 ou 5, **caractérisé en ce que** la composition alcaline aqueuse produit la modification de la surface des substrats de silicium par gravure et oxydation, l'élimination de verre de silicate et de couches mortes générées par le dopage émetteur, l'élimination de silicium poreux généré par l'isolation de bord humide et/ou l'élimination de débris qui ont recontaminé la surface des substrats de silicium.

7. Procédé de fabrication de dispositifs générant de l'électricité par exposition à un rayonnement électromagnétique comprenant les étapes de

(1.I) texturation d'au moins une surface majeure d'un substrat de silicium avec une composition de gravure, de manière à générer une surface hydrophobe ;
(1.II) hydrophilisation de la surface hydrophobe en utilisant le procédé de traitement de la surface du substrat de silicium selon l'une quelconque des revendications 4 à 6 ;
(1.III) application d'au moins une source d'émetteur pulvérisée sur la surface hydrophile ;
(1.IV) chauffage du substrat de silicium mis en contact avec la source d'émetteur, de manière à former des émetteurs dans le substrat de silicium ou des émetteurs dans le substrat de silicium et un verre de silicate au-dessus de la surface du substrat de silicium ;

(1.V) modification de la couche supérieure du substrat de silicium contenant les émetteurs ou élimination du verre de silicate de la surface du semi-conducteur de silicium et, ensuite, modification de la couche supérieure du substrat de silicium contenant les émetteurs, de manière à obtenir une surface hydrophobe ;

(1.VI) hydrophilisation de la surface hydrophobe en utilisant le procédé de traitement de la surface du substrat de silicium selon l'une quelconque des revendications 4 à 6 ;

(1.VII) dépôt d'une couche antireflet au-dessus de la couche supérieure du substrat de silicium modifiée contenant les émetteurs, de manière à obtenir un intermédiaire ; et

(1.VIII) traitement supplémentaire de l'intermédiaire pour obtenir le dispositif ;

à condition que l'étape de processus (1.II) ou l'étape de processus (1.VI) soit conduite ou que les étapes de processus (1.II) et (1.VI) soient toutes deux conduites.

8. Procédé de fabrication selon la revendication 7, **caractérisé en ce qu'**une étape d'isolation de bord humide est conduite avant l'étape de processus (1.VI).

9. Procédé de fabrication selon la revendication 8, **caractérisé en ce que** le procédé de traitement de la surface d'un substrat de silicium selon l'une quelconque des revendications 4 à 6 est conduit après l'étape d'isolation de bord humide.

10. Procédé de fabrication selon l'une quelconque des revendications 7 à 9, **caractérisé en ce que** les dispositifs sont des cellules photovoltaïques et des cellules solaires.

11. Procédé de fabrication de dispositifs générant de l'électricité par exposition à un rayonnement électromagnétique comprenant les étapes de

(2.I) texturation d'au moins une surface majeure d'un substrat de silicium avec une composition de gravure, de manière à générer une surface hydrophobe ;

(2.II) traitement de la surface hydrophobe du substrat de silicium dans une atmosphère chauffée contenant au moins une source d'émetteur gazeuse, de manière à former des émetteurs dans le substrat de silicium ou des émetteurs dans le substrat de silicium et un verre de silicate au-dessus de la surface du substrat de silicium ;

(2.III) modification de la couche supérieure du substrat de silicium contenant les émetteurs ou élimination du verre de silicate de la surface du semi-conducteur à silicium et, ensuite, modification de la couche supérieure du substrat de silicium contenant les émetteurs par le procédé de traitement de la surface d'un substrat de silicium selon l'une quelconque des revendications 4 à 6 ;

(2.IV) dépôt d'une couche antireflet au-dessus de la couche supérieure du substrat de silicium modifiée contenant les émetteurs, de manière à obtenir un intermédiaire ; et

(2.V) traitement supplémentaire de l'intermédiaire pour obtenir le dispositif.

12. Procédé de fabrication selon la revendication 11, **caractérisé en ce qu'**une étape d'isolation de bord humide est conduite avant l'étape de processus (2.IV) .

13. Procédé de fabrication selon la revendication 12, **caractérisé en ce que** le procédé de traitement de la surface d'un substrat de silicium selon l'une quelconque des revendications 4 à 6 est conduit après l'étape d'isolation de bord humide.

14. Procédé de fabrication selon l'une quelconque des revendications 11 to 13, **caractérisé en ce que** les dispositifs sont des cellules photovoltaïques et des cellules solaires.

15. Utilisation d'un système tampon, dans lequel au moins un composant autre que l'eau est volatil pour stabiliser le pH de compositions alcalines aqueuses contenant

(A) au moins un hydroxyde d'ammonium quaternaire ; et
(B) au moins un composant choisi dans le groupe constitué de

(b1a) acides sulfoniques hydrosolubles et leurs sels hydrosolubles de formule générale I :

$$(R\text{-}SO_3^-)_n X^{n+} \qquad (Ia),$$

(b2) acides phosphoniques hydrosolubles et leurs sels hydrosolubles de formule générale II :

$$R\text{-}PO_3^{2-}(X^{n+})_{3-n} \qquad (II),$$

(b3) esters d'acide sulfurique hydrosolubles et leurs sels hydrosolubles de formule générale III :

$$(RO\text{-}SO_3^-)_n X^{n+} \qquad (III),$$

(b4) esters d'acide phosphorique hydrosolubles et leurs sels hydrosolubles de formule générale (IV) :

$$RO\text{-}PO_3^{2}(X^{n+})_{3-n} \qquad (IV),$$

et

(b5) esters d'acide phosphorique hydrosolubles et leurs sels hydrosolubles de formule générale (V) :

$$[(RO)_2 PO_2^-]_n X^{n+} \qquad (V)\ ;$$

où l'indice $n = 1$ ou $2$ ; la variable X est choisie dans le groupe constitué d'hydrogène, ammonium, un métal alcalin et un métal alcalino-terreux ; et la variable R est choisie dans le groupe constitué de fragments aliphatiques ayant 2 à 5 atomes de carbone et au moins une double liaison à insaturation oléfinique, de fragments cycloaliphatiques ayant 4 à 6 atomes de carbone et au moins une double liaison à insaturation oléfinique, et de fragments alkylaryle, dans lesquels les fragments aryle sont choisis parmi benzène et naphtalène, les fragments alkyle sont choisis parmi méthylène, éthanediyle et propanediyle, et l'atome de soufre et l'atome de phosphore dans les formules générales Ia et II sont chacun directement liés et l'atome de soufre dans la formule générale III et l'atome de phosphore dans les formules générales IV et V sont chacun liés via un atome d'oxygène à un atome de carbone aliphatique.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1808480 A1
- EP 2281867 A1
- EP 1914296 A2
- JP 50158281 A
- US 4239661 A
- DE 2749636
- JP 63048830 A
- JP 63274149 A
- US 5129955 A
- US 5207866 A
- EP 0496602 A2
- US 5705089 A

- EP 0665582 A2
- US 5466389 A
- US 5498293 A
- US 6465403 B1
- US 6585825 B1
- US 6417147 B
- WO 0233033 A1
- US 20060154839 A1
- US 20060226122 A
- US 20100319735 A1
- US 20060226122 A1